(19) **Europäisches Patentamt**
**European Patent Office**
**Office européen des brevets**

(11) **EP 2 094 905 B1**

(12) **EUROPEAN PATENT SPECIFICATION**

(45) Date of publication and mention
of the grant of the patent:
**15.01.2014 Bulletin 2014/03**

(51) Int Cl.:
*H05K 1/03* *(2006.01)*    *H05K 1/09* *(2006.01)*
*H05K 3/28* *(2006.01)*    *A41D 31/00* *(2006.01)*
*D06N 3/18* *(2006.01)*    *D06N 7/00* *(2006.01)*
*F41H 1/02* *(2006.01)*    *F41H 3/02* *(2006.01)*
*F41H 5/04* *(2006.01)*    *H05B 3/34* *(2006.01)*
*F28F 21/00* *(2006.01)*

(21) Application number: **07851669.7**

(22) Date of filing: **20.12.2007**

(86) International application number:
**PCT/KR2007/006703**

(87) International publication number:
**WO 2008/075915 (26.06.2008 Gazette 2008/26)**

(54) **HEATING FABRIC AND METHOD FOR FABRICATING THE SAME**

ERWÄRMUNGSGEWEBE UND VERFAHREN ZU SEINER HERSTELLUNG

TISSU CHAUFFANT ET PROCÉDÉ DE FABRICATION ASSOCIÉ

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **20.12.2006 KR 20060131004**
        **12.07.2007 KR 20070070173**

(43) Date of publication of application:
**02.09.2009 Bulletin 2009/36**

(73) Proprietor: **Kolon Glotech Inc.**
**Gwacheon-si, Gyeonggi-do 427-040 (KR)**

(72) Inventors:
• **PARK, Sung Mee**
**Atlanta, GA 30341 (US)**

• **CHO, Kwang Su**
**Yongin-si**
**Gyeonggi-do 446-772 (KR)**
• **CHUNG, Kyung Hee**
**Seoul 150-768 (KR)**

(74) Representative: **Szabo, Zsolt**
**Danubia**
**Patent & Law Office LLC**
**POB 198**
**1368 Budapest (HU)**

(56) References cited:
**KR-A- 20050 092 461**    **KR-A- 20060 084 674**
**KR-Y1- 200 402 130**    **US-A- 3 935 422**
**US-A- 5 216 536**    **US-A- 5 500 759**
**US-A1- 2003 211 797**    **US-A1- 2004 055 699**

## Description

Technical Field

The present invention relates to a conductive fabric, and more particularly to a heating fabric and a method for fabricating the same.

Background Art

Smart wear is a new type of product that is designed to apply a new fiber technology for signal transmission to and embed various digital devices in a textile fashion product to utilize the digitalized properties of the digital devices anytime and anywhere. That is, smart wear is a new type of clothing that is manufactured by providing desired digitalized properties to a fiber material or clothing while maintaining the nature of the fiber material or clothing. Accordingly, smart wear is required to transmit digital signals while producing a tactile feeling and physical properties identical to general textiles. In conclusion, smart wear refers collectively to a new concept of clothing that combines high-function material properties (*e.g.,* sensing of external stimuli and self-response to the stimuli) of fibers or clothes with digitalized properties, which are not found in clothes and textiles.

Smart wear has been developed for military applications since the mid-1990's and is currently being developed in various fields, particularly clothing and medical applications. In particular, smart materials based on electronic printing technology can be used to manufacture military textile products for wearable computers. Textile-based electronic circuits can be designed by applying electronic printing technology to smart materials in such a way that conductive fibers or textiles having characteristics and electrical properties of clothing are connected to various electronic components and parts Interconnection method. Therefore, electronic printing technology is of great value in the development of smart wear.

For example, the application of electronic printing technology to military uniforms offers the possibility to reduce the weight and volume of the military uniforms, thus enabling the development of military uniforms integrated with desired functions, such as injury healing and communication. Soldiers must still carry as much as 45 kg of equipment when fully armed for modern high-tech warfare.

Recently, heating fabrics have been introduced. These heating fabrics perform a function to generate heat by measuring body temperature and outer circumstance such as temperature, humidity, ultraviolet, and so forth. However, there is great demand of more comfortable wear and washing fastness.

U.S. Patent No. 3,935,422 discloses a flexible heating fabric comprising a base layer composed of a synthetic, regenerated or natural fiber an insulating layer, a primer layer formed on the base layer, a heating layer formed on the primer layer and a conductive layer in contact with the heating layer, wherein the insulating layer is formed on the conductive layer.

U.S. Patent Appl. No. 2004/0055699 A1 relates to a method of accelerating the curing of an adhesive at a bondline while bonding structures using a fabric heater.

Accordingly, a technique of FPFCB (Flexible Print Fabric Circuit Board) applying electric conductive material is required. In other words, data can be transferred by printing electric conductive material on fabrics.

To meet this demand, various proposals have been made. For example, electric conductive material having excellent durability, a technique for printing conductive material on fabrics, circuit based on fabrics, and post-finishing for maintaining and improving performance of printed conductive materials.

## Disclosure of Invention

### Technical Problem

The present invention has been made in an effort to solve the above problems, and it is an object of the present invention to provide a heating fabric in which a circuit can be freely formed without any restriction to dynamic wearability to form a heating portion, and a method for fabricating the same.

It is another object of the present invention is to provide a heating fabric capable of reducing electric power and improving heating characteristic and a method for fabricating the same.

It is still another object of the present invention is to provide a heating fabric that is free from any defect or circuit failure by circuit disconnection, and a method for fabricating the same.

It is yet another object of the present invention is to provide a heating fabric that exhibits satisfactory electrical properties without deteriorating the intrinsic physical properties of a textile usable as a material for clothing, and a method for fabricating the same.

It is still yet another object of the present invention is to provide a heating fabric in which one or more bent portions of a circuit are designed to be modified to allow electricity to smoothly flow, and a method for fabricating the same.

It is still yet another object of the present invention is to provide a heating fabric having excellent abrasion strength and flexibility by changing the formation sequence of a heating layer and a conductive layer and a method for fabricating the same.

It is still yet another object of the present invention is to provide a heating fabric having excellent durability and improving insulation by changing a composition of an insulating layer at one surface or both surfaces of the heating fabric and a method for fabricating the same.

**Technical Solution**

Pursuant to the present invention, a heating fabric comprises the features of claim 1.

According to certain embodiments of the present invention, a primer layer is further included. The primer layer is formed between the base layer and the conductive layer to make the surface of the base layer uniform.

Pursuant to further embodiments of the present invention, the primer layer is formed of at least one resin selected from the group consisting of polyurethane, acrylic and silicone resins.

Pursuant to still further embodiments of the present invention, the primer layer is formed of a multi-layered layer together with a water-repellent layer.

Pursuant to still further embodiments of the present invention, the heating layer or the conductive layer is formed of a conductive material and a mixture thereof with a binder.

Pursuant to still further embodiments of the present invention, the conductive material is formed of at least one selected from the group consisting of a conductive polymer, carbon, silver, gold, platinum, palladium, copper, aluminum, tartar, iron, and nickel.

Pursuant to still further embodiments of the present invention, the binder is formed of at least one selected from the group consisting of polyurethane resins, acrylic resins, silicone resins, melamine resins, epoxy resins, and mixtures thereof.

Pursuant to still further embodiments of the present invention, the binder is formed of water dispersed-polyurethane.

Pursuant to still further embodiments of the present invention, the conductive polymer is selected from the group consisting of polyaniline, polypyrrole, polythiophene, and mixtures thereof.

Pursuant to still further embodiments of the present invention, the conductive material and the binder are mixed in a weight ratio of 90:10 to 80:20 to form the conductive layer.

Pursuant to still further embodiments of the present invention, the conductive layer and the heating layer are contact at two or more points.

Pursuant to still further embodiments of the present invention, the conductive layer or the heating layer have a thickness of 2 mm to 500 mm.

Pursuant to still further embodiments of the present invention, the conductive layer has a width of 10 mm to 20 mm.

Pursuant to still further embodiments of the present invention, the insulating layer is formed by coating, printing or laminating at least one resin selected from the group consisting of polyurethane, acrylic, silicone, polyester, polyvinyl chloride (PVC) and polytetrafluoroethylene (PTFE).

Pursuant to still further embodiments of the present invention, the conductive layer has the enlarged portions of bent portions of a circuit whose width is larger than that of linear portions of the circuit.

Pursuant to still further embodiments of the present invention, the enlarged portions have a circular or oval shape.

Pursuant to still further embodiments of the present invention, the heating fabric has a resistance difference of 0.5 W to 4 W before and after washing.

Pursuant to the present invention, a method for fabricating a heating fabric comprises the features of claim 16.

Pursuant to embodiments of the present invention, a method for fabricating a heating fabric comprising: forming a conductive layer on a base layer composed of a synthetic, regenerated or natural fiber; forming a heating layer wholly or partially in contact with the conductive layer on an upper surface, a lower surface, or the same surface of the heating layer as a line or a surface; and forming an insulating layer on the conductive layer and the heating layer for electric shield.

Pursuant to embodiments of the present invention, a method for fabricating a heating fabric comprising: simultaneously forming a conductive layer and a heating layer on a base layer composed of a synthetic, regenerated or natural fiber; and forming an insulating layer on the conductive layer and the heating layer for electric shield.

Pursuant to some embodiments of the present invention, calendering the base layer using a pressing roller before the formation of the conductive layer to make the surface of the base layer smooth, offset pores of the base layer and enhance the flex resistance of the conductive fabric is further included.

Pursuant to another embodiments of the present invention, forming a primer layer on the base layer to maintain the thickness of the conductive layer and the heating layer at a constant level before forming the conductive layer and the heating layer is further included.

Pursuant to yet another embodiment of the present invention, the primer layer is formed by knife rolling, over roll coating, floating knife coating, or knife over roll coating, laminating, printing, or gravure printing.

Pursuant to further embodiments of the present invention, the primer layer is formed of a multi-layered layer together with a water-repellent layer.

Pursuant to still further embodiments of the present invention, the primer layer is selected from the group consisting of polyurethane resins, acrylic resins, and silicone resins.

Pursuant to still further embodiments of the present invention, moisture water proofing/water proofing to enhance insulation, water fastness, and the flex resistance of the conductive fabric is further included.

Pursuant to still further embodiments of the present invention, the heating layer or the conductive layer are coated by at least one selected from the group consisting of coating, printing, and transfer-style printing.

Pursuant to still further embodiments of the present invention, the heating layer or the conductive layer is formed of a conductive material or a mixture thereof with a binder.

Pursuant to still further embodiments of the present invention, the conductive material is formed of at least one selected from the group consisting of a conductive polymer, carbon, silver, gold, platinum, palladium, copper, aluminum, tartar, iron, and nickel.

Pursuant to still further embodiments of the present invention, the binder is formed of at least one selected from the group consisting of polyurethane resins, acrylic resins, silicone resins, melamine resins, epoxy resins, and mixtures thereof.

Pursuant to still further embodiments of the present invention, the binder is formed of water dispersed-polyurethane.

Pursuant to still further embodiments of the present invention, the conductive polymer is selected from the group consisting of polyaniline, polypyrrole, polythiophene, and mixtures thereof.

Pursuant to still further embodiments of the present invention, the conductive material and the binder are mixed in a weight ratio of 90:10 to 80:20 to form the conductive layer.

Pursuant to still further embodiments of the present invention, the conductive layer and the heating layer are contact at two or more points.

Pursuant to still further embodiments of the present invention, the conductive layer or the heating layer have a thickness of 2 mm to 500 mm.

Pursuant to still further embodiments of the present invention, the conductive layer has a width of 10 mm to 20 mm.

Pursuant to still further embodiments of the present invention, the insulating layer is formed by coating, printing or laminating at least one resin selected from the group consisting of polyurethane, acrylic, silicone, polyester, polyvinyl chloride (PVC) and polytetrafluoroethylene (PTFE) resins on the conductive layer.

Pursuant to still further embodiments of the present invention, the insulating layer is formed by drying in case of direct coating or hot-melt dot or gravure in case of laminating.

Pursuant to still further embodiments of the present invention, the conductive layer has the enlarged portions of bent portions of a circuit whose width is larger than that of linear portions of the circuit.

Pursuant to still further embodiments of the present invention, the enlarged portions have a circular or oval shape.

Pursuant to still further embodiments of the present invention, the heating fabric has a resistance difference of 0.5 W to 4 W before and after washing.

**Advantageous Effects**

According to the heating fabric and the method of the present invention, a heating fabric in which a pattern can be freely formed without any restriction to ensure dynamic wearability as well as to perform heating function is provided.

Further, according to the heating fabric and the method of the present invention, a circuit can be designed regardless of bending or folding due to the elasticity and flexibility of a fiber as a material for a base layer to substantially prevent the circuit from damage, such as disconnection.

Further, according to the heating fabric and method of the present invention, the heating fabric can be fabricated in a continuous process.

Further, the heating fabric and method of the present invention show electrical conductivity (*i.e.* electricity flow) while retaining inherent functions (*e.g.,* coatability, comfort, breathable waterproofness and tensile strength) of fabric (*i.e.* clothing).

Further, according to the heating fabric and the method of the present invention, a heating layer and/or a conductive layer can be maintained uniform due to the presence of a primer layer to allow a constant electric current to flow therethrough.

Further, according to the heating fabric and the method of the present invention, bent portions of a circuit are formed in a circular or oval shape by printing a pattern on a heating layer and/or a conductive layer, so that sectional area is enlarged to smoothly allow electric current to flow therethrough.

Further, according to the heating fabric and the method of the present invention, an insulating layer is made of a material compatible with a heating layer and/or a conductive layer to improve tensile strength and elongation.

Advantageously, abrasion and flex resistance can be controlled depending on a sequence of printing a heating layer and/or a conductive layer.

Moreover, the heating fabric has a endurance with respect to washing by coating an insulating layer at one surface or both surfaces thereof.

**Brief Description of the Drawings**

FIGs. 1 to 3 are cross-sectional views of a heating fabric according to a preferred embodiment of the present invention.

FIGs. 4 and 5 are process charts illustrating methods for fabricating heating fabrics according to embodiments of the present invention.

FIG. 6 is a cross-sectional view showing a bent portion of a circuit according to a preferred embodiment of the present invention.

FIGs. 7 to 10 are graphs showing a change of tensile strength and elongation according to a kind of binders.

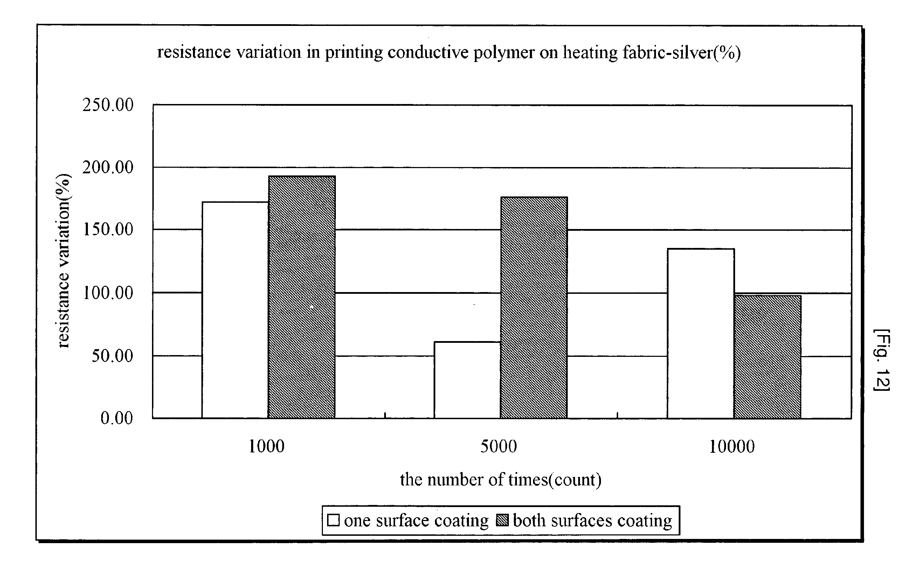

FIGs. 11 and 12 are graphs showing variations in the resistance of the formation sequence of a heating layer and/or a conductive layer.

<Brief explanation of essential parts of the drawings>

10: Heating fabric, 100: Base layer,

200: Primer layer, 300: Heating layer

400: Conductive layer, 500: Insulating layer

**Best Mode for Carrying Out the Invention**

Embodiments of the present invention now will be described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout.

As used herein, the terms "about", "substantially", etc. are intended to allow some leeway in mathematical exactness to account for tolerances that are acceptable in the trade and to prevent any unconscientious violator from unduly taking advantage of the disclosure in which exact or absolute numerical values are given so as to help understand the invention.

As utilized herein, the term "fabric" is intended to include articles produced by weaving or knitting, non-woven fabrics, fiber webs, and so forth.

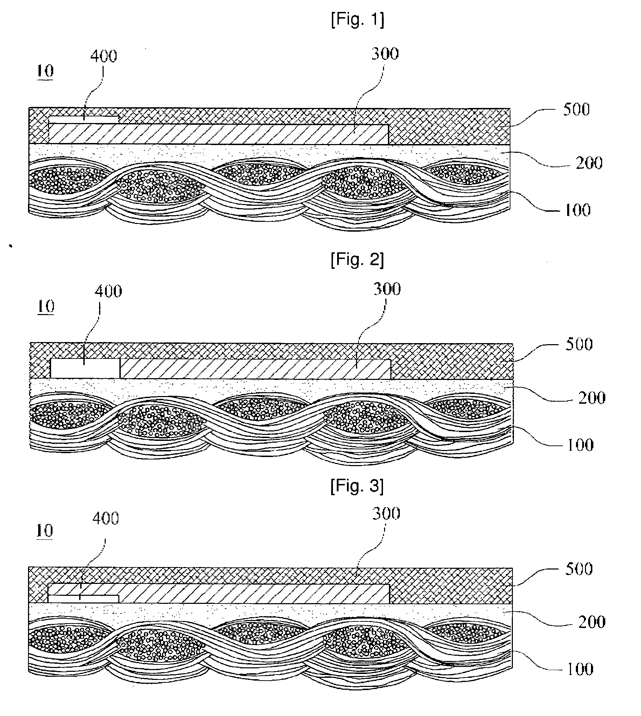

FIGs. 1 to 3 are cross-sectional views of a heating fabric according to a preferred embodiment of the present invention.

Referring to FIGs. 1 to 3, a heating fabric 10 according to the present invention comprises a base layer 100, a primer layer 200, a heating layer 300, a conductive layer 400, and an insulating layer 500. Optionally, the primer layer 200 may be omitted.

Any type of woven or knitted fabric, non-woven fabric, fiber web or so forth may be used to form the base layer 100. There is no particular limitation on the material and formation method of the base layer. For example, the base layer 100 may be composed of a synthetic fiber (*e.g.,* polyester, polyamide or polyurethane), a cellulose regenerated fiber (*e.g.,* rayon or acetate) or a natural fiber (*e.g.,* cotton or wool).

The base layer 100 has a very non-uniform microscopic surface and extremely many fine pores due to gaps between fiber filaments. The primer layer 200 formed on the base layer 100 makes the surface of the base layer 100 uniform and allows the conductive layer to be formed to a uniform thickness. The primer layer 200 prevents a constituent material of the conductive layer from penetrating the base layer 100. The primer layer 200 may be optionally formed on the base layer 100. Thus, it is to be understood that the primer layer 200 can be excluded according to the characteristics of the conductive fabric.

The primer layer 200 may be formed of at least one resin selected from the group consisting of polyurethane, acrylic and silicone resins.

The primer layer may be formed in a monolayer or multi-layered layer together with a water-repellent layer (not shown). The water-repellent layer can be formed by a common water-repellent processing method. Non-limiting examples of suitable materials for the water-repellent layer include fluorine and silicone. The water-repellent layer may be formed on or under the fabric of the conductive layer and/or the heating layer to prevent the resin constituting the conductive layer and/or the heating layer from permeating into the base layer 100.

The heating layer 300 can be formed on the primer layer 200. The heating layer 300 can be pre-designed and is formed by coating a conductive material or a mixture of a binder and the conductive material. The conductive material as the conductive polymer may be is selected from the group consisting of polyaniline, polypyrrole, polythiophene or a conductive carbon black mixed therewith. In addition, the conductive carbon block may be equivalent to at least one selected from the group consisting of carbon, silver, gold, platinum, palladium, copper, aluminum, tartar, iron, and nickel.

FIG. 1 shows the conductive layer 400 on the heating layer 300 according to an embodiment of the present invention. The conductive layer 400 is pre-designed and may be partially formed on or under the heating layer 300.

Meanwhile, FIG. 2 shows the conductive layer 400 is formed at the same surface as the heating layer 300. The conductive layer 400 may be formed as the same or other pattern as the heating layer 300.

FIG. 3 shows the conductive layer 400 under the heating layer 300 in accordance with another embodiment of the present invention.

The conductive layer 300 may be formed of at least one material selected from the group consisting of a conductive polymer, carbon, a metal material such as silver, and a mixture thereof with a binder. For example, the conductive layer 300 is formed of a dispersion of an electrically-conductive filler in a vehicle, which is printed to form an electrically conductive cured film. Typical applications of the conductive layer 300 are LCD electrode printing, touch screen printing, conductive pattern printing for circuit boards, contact and pattern printing of thin-film switch plates and electromagnetic shielding. Non-limiting examples of suitable conductive fillers for use in the present invention include conductive metals, such as silver, platinum, palladium, copper and nickel. Preferred is silver.

The binder is formed of at least one selected from the group consisting of polyurethane resins, acrylic resins, silicone resins, melamine resins, epoxy resins, and mixtures thereof.

The metal material and the binder may be mixed in a weight ratio of 90:10 to 80:20 to form the conductive layer. The binder excesses the range, conductive characteristic becomes low, whereas the binder is under the range, adhesion becomes low.

The heating layer 300 and/or conductive layer 400 preferably have a thickness of 2 mm to 500 mm. When the thickness of the conductive layer is below the range, it is difficult to ensure the thickness uniformity of the conductive layer. Meanwhile, when the thickness of the conductive layer is above the range, a decrease in resistance is caused, leading to an increase in power consumption. The conductive layer 400 preferably has a width of 10 mm to 20 mm. Although an increase in the width of the conductive layer 400 leads to a reduction in resistance and a stable flow of electricity, an excessive increase in the width of the conductive layer 400 without limitation causes the problems of increased production costs and poor coatability. It is preferred that the conductive fabric of the present invention has a resistance difference of 0.5 W to 4 W before and after washing. It is actually difficult to attain the resistance difference below this range, and the resistance difference above this range impedes the stable flow of electricity.

The insulating layer 500 is formed on the heating layer 200 and/or the conductive layer 400. The insulating layer 500 may be formed by coating, printing or laminating at least one resin selected from the group consisting of polyurethane, acrylic, silicone, polyester, polyvinyl chloride (PVC) and polytetrafluoroethylene (PTFE) resins on the conductive layer 300. The insulating layer 500 performs a function to protect the conductive layer from damage, such as cracks, impart flexibility to the fabric, and render the fabric moisture-waterproof or waterproof.

Hereinafter, methods for fabricating heating fabrics according to preferred embodiments of the present invention will be provided.

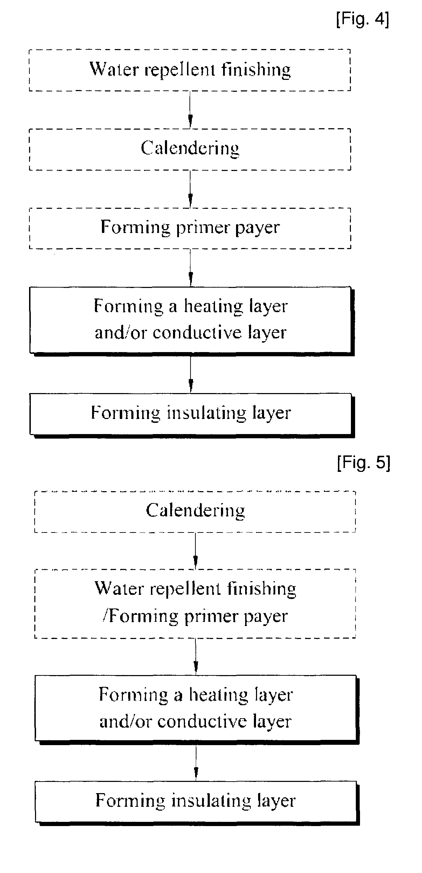

FIGs. 4 and 5 are process charts illustrating methods for fabricating heating fabrics according to embodiments of the present invention.

A woven or knitted textile as a material for a base layer 100 is introduced between two pressing rollers to compensate surface irregularities of the textile (calendering). This calendering is performed to make the surface of the base layer 100 smooth, offset pores of the base layer 100 and enhance the flex resistance of the conductive fabric. This calendering is optional depending on the characteristics of the fabric of the base layer 100.

A primer layer 200 is formed on the base layer, which has optionally undergone calendering, to achieve more active control of the surface pores of the base layer and uniform thickness of the heating layer 300 and/or the conductive layer 400 to be formed thereon. The primer layer 200 may be formed by knife rolling, over roll coating, floating knife coating, knife over roll coating, laminating, printing or gravure coating. The formation of the primer layer 200 is optional.

The primer layer 200 may be a multi-layered layer together with a water-repellent layer. The water-repellent layer can be formed before or after the calendering step. The process chart of FIG. 4 illustrates the formation of the water-repellent layer before the calendering, and the process chart of FIG. 5 illustrates the formation of the water-repellent layer and/or the primer layer 200 after the calendering, but the method of the present invention is not limited thereto.

The heating layer 300 and/or the conductive layer 400 are formed on the primer layer 200 or the base layer 100. The heating layer 300 and/or the conductive layer 400 are previously designed. The heating layer 300 and/or the conductive layer 40 can be formed by various techniques, such as coating, printing and transfer printing. In a particular embodiment of the present invention, the heating layer 300 and/or the conductive layer 400 are formed by printing. In this case, a circuit can be designed in the conductive fabric according to the pre-designed pattern, regardless of the placement of an electronic device.

In view of the foregoing, the heating fabric of the present invention can be termed a 'flexible printed fabric circuit board (FPFCB)'.

Patterns of printed fabric circuit may be formed in order to measure resistance value of respective heating portions. In this case, the heating portions depend on the length and width of conducting line.

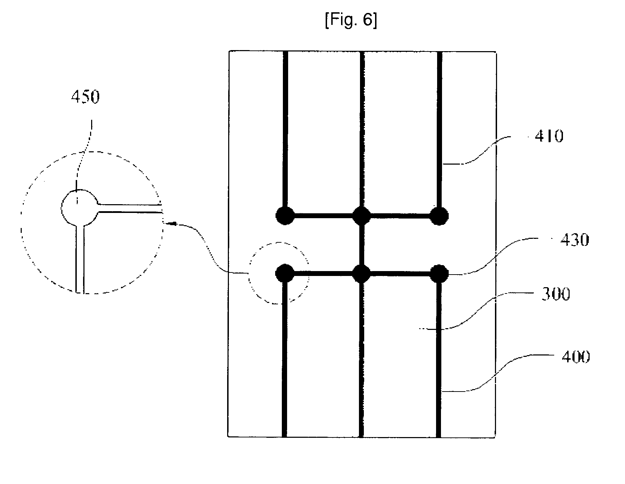

FIG. 6 shows the heating layer and the conductive layer formed on the textiles according to an embodiment of the present invention. Specifically, FIG. 6 illustrates a circuit pattern having the enlarged portion 450 of bent portions 430 whose width is larger than that of linear portions 410 of the circuit pattern. The enlarged portions 450 may have any shape. For example, the enlarged portions 450 have a circular or oval shape.

The reason why the bent portions are wider than the linear portions can be supported by the following equations:

$$W = I^2 R$$

$$R = \rho \cdot L/S$$

(W: power, R: resistance, p: specific resistance, L: length of conducting line, and S: cross-sectional area).

As the cross-sectional area increases, the resistance decreases and the flow of electricity increases. Accordingly, a larger amount of current flows in the wider enlarged portions 350 than in the linear portions 310.

A sudden change (*i.e.* surge) in electric current is caused in the bent portions 330 at predetermined angles, such as right angles, to generate heat.

A surge refers to a transient waveform of electric current, voltage or power that abruptly increases within a short time and gradually decreases during flow along an electric wire or circuit. A surge is mainly responsible for electricity interruption, telephone disconnection and damage to sensitive semiconductors when lightning flashes. Since sudden over-voltage, particularly strong or long surge in a power line may cause dielectric breakdown or disorder of electronic devices, a surge protector or inhibitor is installed between a power supply terminal and a computer terminal to inhibit or minimize a change in electric current.

Thus, the resistance is reduced by varying the area of the bent portions 430 to minimize the occurrence of surge and allow the electricity to smoothly flow through the conductive layer despite an increase in the amount of current.

It is preferred that the heating layer 300 and/or the conductive layer 400 have a thickness of 2 mm to 500 mm and a width of 10 mm to 20 mm. It is preferred to maintain the resistance difference of the heating fabric before and after washing at 0.5-4 W. The heating layer may be composed of 1-30% by weight of carbon and 1-70% by weight of silver. A binder that can be used to form the conductive layer is selected from the group consisting of polyurethane resins, acrylic resins, silicone resins, melamine resins, epoxy resins, and mixtures thereof, which are compatible with the primer layer 200 (moisture-waterproof/waterproof treatment step).

After the heating layer 300 and/or the conductive layer 400, the insulating layer 500 may be formed on them. The insulating layer 500 may be formed by coating, printing or laminating at least one resin selected from the group consisting of polyurethane, acrylic, silicone, polyester, polyvinyl chloride (PVC) and polytetrafluoroethylene (PTFE) resins on the conductive layer. Dry coating, hot-melt dot lamination or gravure lamination is preferably employed to form the insulating layer.

The coating composition for the insulating layer causes a variation in resistance, thereby affecting the durability of the insulating layer.

The insulating layer can be formed on one or both surfaces of the conductive fabric. Taking into consideration the fact that the heating fabrics undergo washing several times, the choice of a suitable coating composition for long-term insulation, *i.e.* excellent wash fastness, is an important factor.

After the calendering step, the base layer 100 can be selectively subjected to breathable waterproof treatment or waterproof treatment. Pores formed after the breathable waterproof treatment or waterproof treatment serve to offset the pores of the base layer and to achieve enhanced insulating properties, wash resistance and flex resistance of the conductive fabric. A material used for the breathable waterproof treatment is preferably a resin compatible with the conductive material (moisture-waterproof/waterproof treatment step).

Consequently, according to the method of the present invention, the need to previously form a region through which electricity flows in designing the conductive fabric is avoided, a conductive region can be directly formed in already-fabricated fabric or clothing, and no restriction is imposed on the wearability of the conductive fabric despite the presence of the conductive region to ensure dynamic wearability of the conductive fabric.

**Mode for the Invention**

**EXAMPLES**

Example 1

A polyester plain weave fabric as a base layer was subjected to calendering and a solvent-type polyurethane resin was used to form a primer layer thereon. A silver paste was applied to the primer layer by screen printing to form a conductive layer, and then a heating layer is formed on the primer layer using polypyrrole resins by screen printing at one time. In this case, acrylic adhesion was used as a binder. The shape of bent portions, which is formed as a pre-designed heating pattern, of a circuit is circular. After that, an insulating layer is formed at one surface thereof by coating a moisture-polyurethane.

Example 2

A heating fabric was fabricated in the same manner as in Example 1, except that polyurethane cross-link agent was used as binders of a conductive layer.

Example 3

A heating fabric was fabricated in the same manner as in Example 1, except that an insulating layer was formed by coating at both surfaces of a heating layer and/or a conductive layer.

Example 4

A heating fabric was fabricated in the same manner as in Example 2, except that an insulating layer was formed by coating at both surfaces of the fabric.

Example 5

The heating fabric was fabricated in the same manner as in Example 1, except that a conductive layer was formed after printing a heating layer.

Example 6

A heating fabric was fabricated in the same manner as in Example 5, except that polyurethane cross-link agent was used as binders of a heating layer and/or a conductive layer.

Example 7

A heating fabric was fabricated in the same manner as in Example 5, except that an insulating layer was formed by coating at both surfaces of the fabric.

Example 8

A heating fabric was fabricated in the same manner as in Example 6, except that an insulating layer was formed by coating at both surfaces of the fabric.

Example 9

A heating fabric was fabricated in the same manner as in Example 6, except that an insulating layer is formed at one surface of the fabric using solvent-dispersion silicon (A company) as a coating composition of the insulating layer.

Example 10

A heating fabric was fabricated in the same manner as in Example 9, except that polyurethane cross-link agent was used as binders of a heating layer and/or a conductive layer.

Example 11

A heating fabric was fabricated in the same manner as in Example 9, except that an insulating layer was formed by coating at both surfaces of the fabric.

Example 12

A heating fabric was fabricated in the same manner as in Example 10, except that an insulating layer was formed by coating at both surfaces of the fabric.

Example 13

A heating fabric was fabricated in the same manner as in Example 9, except that a conductive layer is formed by screen printing after forming a heating layer.

Example 14

A heating fabric was fabricated in the same manner as in Example 13, except that polyurethane cross-link agent was used as binders of a heating layer and/or a conductive layer.

Example 15

A heating fabric was fabricated in the same manner as in Example 13, except that an insulating layer was formed by coating at both surfaces of the fabric.

Example 16

A heating fabric was fabricated in the same manner as in Example 14, except that an insulating layer was formed by coating at both surfaces of the fabric.

Example 17

A heating fabric was fabricated in the same manner as in Example 1, except that an insulating layer is formed at one surface of the fabric using solvent-dispersion silicon (B Company) as a coating composition of the insulating layer.

Example 18

A heating fabric was fabricated in the same manner as in Example 17, except that polyurethane cross-link agent was used as binders of a heating layer and/or a conductive layer.

Example 19

A heating fabric was fabricated in the same manner as in Example 17, except that an insulating layer was formed by coating at both surfaces of the fabric.

Example 20

A heating fabric was fabricated in the same manner as in Example 18, except that an insulating layer was formed by coating at both surfaces of the fabric.

Example 21

A heating fabric was fabricated in the same manner as in Example 17, except that a conductive layer is formed by screen printing after forming a heating layer.

Example 22

A heating fabric was fabricated in the same manner as in Example 21, except that polyurethane cross-link agent was used as binders of a heating layer and/or a conductive layer.

Example 23

A heating fabric was fabricated in the same manner as in Example 21, except that an insulating layer was formed by coating at both surfaces of the fabric.

Example 24

A heating fabric was fabricated in the same manner as in Example 22, except that an insulating layer was formed by coating at both surfaces of the fabric.

Example 25

A heating fabric was fabricated in the same manner as in Example 1, except that an insulating layer was formed at one surface thereon using a liquid silicone rubber.

Example 26

A heating fabric was fabricated in the same manner as in Example 25, except that polyurethane cross-link agent was used as binders of a heating layer and/or a conductive layer.

Example 27

A heating fabric was fabricated in the same manner as in Example 25, except that an insulating layer was formed by coating at both surfaces of the fabric.

Example 28

A heating fabric was fabricated in the same manner as in Example 26, except that an insulating layer was formed by coating at both surfaces of the fabric.

Example 29

A heating fabric was fabricated in the same manner as in Example 25, except that polyurethane cross-link agent was used as binders of a heating layer and/or a conductive layer.

Example 30

A heating fabric was fabricated in the same manner as in Example 29, except that polyurethane cross-link agent was used as binders of a heating layer and/or a conductive layer.

Example 31

A heating fabric was fabricated in the same manner as in Example 29, except that an insulating layer was formed by coating at both surfaces of the fabric.

Example 32

A heating fabric was fabricated in the same manner as in Example 30, except that an insulating layer was formed by coating at both surfaces of the fabric.

Comparative Example 1

A polyester plain weave fabric as a base layer was subjected to calendering and a solvent-type polyurethane resin was used to form a primer layer thereon, except that a heating layer and/or a conductive layer was not formed, and an insulating layer was not formed.

Comparative Example 2

A heating fabric was fabricated in the same manner as in Comparative Example 1, except that an insulating layer is formed at one surface of the fabric using solvent-dispersion polyurethane as a coating composition of the insulating layer.

Comparative Example 3

A heating fabric was fabricated in the same manner as in Comparative Example 2, except that an insulating layer was formed by coating at both surfaces of the fabric.

Comparative Example 4

A heating fabric was fabricated in the same manner as in Comparative Example 1, except that an insulating layer is formed at one surface of the fabric using solvent-dispersion silicon A as a coating composition of the insulating layer.

Comparative Example 5

A heating fabric was fabricated in the same manner as in Comparative Example 4, except that an insulating layer was formed by coating at both surfaces of the fabric.

Comparative Example 6

A heating fabric was fabricated in the same manner as in Comparative Example 1, except that an insulating layer is formed at one surface of the fabric using solvent-dispersion silicon B as a coating composition of the insulating layer.

Comparative Example 7

A heating fabric was fabricated in the same manner as in Comparative Example 6, except that an insulating layer was formed by coating at both surfaces of the fabric.

Comparative Example 8

A heating fabric was fabricated in the same manner as in Comparative Example 1, except that an insulating layer was formed at one surface thereon using a liquid silicone rubber.

Comparative Example 9

A heating fabric was fabricated in the same manner as in Comparative Example 8, except that an insulating layer was formed by coating at both surfaces of the fabric.

Comparative Example 10

A heating fabric was fabricated in the same manner as in Example 1, except that an insulating layer was not formed.

Comparative Example 11

A heating fabric was fabricated in the same manner as in Comparative Example 10, except that a polyurethane adhesion was used as binders of a heating layer and/or a conductive layer.

Comparative Example 12

A heating fabric was fabricated in the same manner as in Comparative Example 10, except that a conductive layer is formed after forming a heating layer.

Comparative Example 13

A heating fabric was fabricated in the same manner as in Comparative Example 12, except that a polyurethane adhesion was used as binders of a heating layer and/or a  conductive layer.

**TABLE 1**

| NO. | Example No | Printing Sequence | | Binder | | Insulating layer — Coating Composition | | | | | | | |
|---|---|---|---|---|---|---|---|---|---|---|---|---|---|
| | | Conductive layer → Heating layer | Heating layer → Conductive layer | Acryl | Urethane | Solvent-dispersion Polyurethane | | Solvent-dispersion Silicon A | | Solvent-dispersion Silicon B | | Liquid Silicon Rubber | |
| | | | | | | One Surface | Both Surfaces | One Surface | Both Surfaces | One Surface | Both Surfaces | One Surface | Both Surfaces |
| 1 | Example1 | O | | O | | O | | | | | | | |
| 2 | Example2 | O | | | O | O | | | | | | | |
| 3 | Example3 | O | | O | | | O | | | | | | |
| 4 | Example4 | O | | | O | | O | | | | | | |
| 5 | Example5 | | O | O | | O | | | | | | | |
| 6 | Example6 | | O | | O | O | | | | | | | |
| 7 | Example7 | | O | O | | | O | | | | | | |
| 8 | Example8 | | O | | O | | O | | | | | | |
| 9 | Example9 | O | | O | | | | O | | | | | |
| 10 | Example 10 | O | | | O | | | O | | | | | |
| 11 | Example 11 | O | | O | | | | | O | | | | |
| 12 | Example 12 | O | | | O | | | | O | | | | |
| 13 | Example 13 | | O | O | | | | O | | | | | |
| 14 | Example 14 | | O | | O | | | O | | | | | |
| 15 | Example 15 | | O | O | | | | | O | | | | |
| 16 | Example 16 | | O | | O | | | | O | | | | |
| 17 | Example 17 | O | | O | | | | | | O | | | |
| 18 | Example 18 | O | | | O | | | | | O | | | |
| 19 | Example 19 | O | | O | | | | | | | | O | |
| 20 | Example 20 | O | | | O | | | | | | | O | |

EP 2 094 905 B1

(continued)

| NO. | Example No | Printing Sequence - Conductive layer → Heating layer | Printing Sequence - Heating layer → Conductive layer | Binder - Acryl | Binder - Urethane | Solvent-dispersion Polyurethane - One Surface | Solvent-dispersion Polyurethane - Both Surfaces | Solvent-dispersion Silicon A - One Surface | Solvent-dispersion Silicon A - Both Surfaces | Solvent-dispersion Silicon B - One Surface | Solvent-dispersion Silicon B - Both Surfaces | Liquid Silicon Rubber - One Surface | Liquid Silicon Rubber - Both Surfaces |
|---|---|---|---|---|---|---|---|---|---|---|---|---|---|
| 21 | Example 21 | | O | O | | | | | | O | | | |
| 22 | Example 22 | | O | | O | | | | | O | | | |
| 23 | Example 23 | | O | O | | | | | | | O | | |
| 24 | Example 24 | | O | | O | | | | | | O | | |
| 25 | Example 25 | O | | O | | | | | | | | O | |
| 26 | Example 26 | O | | | O | | | | | | | O | |
| 27 | Example 27 | O | | O | | | | | | | | | O |
| 28 | Example 28 | O | | | O | | | | | | | | O |
| 29 | Example 29 | | O | O | | | | | | | | O | |
| 30 | Example 30 | | O | | O | | | | | | | O | |
| 31 | Example 31 | | O | O | | | | | | | | | O |
| 32 | Example 32 | | O | | O | | | | | | | | O |
| 33 | Comparative Example 1 | - | - | - | - | - | - | - | - | - | - | - | - |
| 34 | Comparative Example 2 | | | | | O | | | | | | | |
| 35 | Comparative Example3 | | | | | | O | | | | | | |
| 36 | Comparative Example4 | | | | | | | O | | | | | |
| 37 | Comparative Example5 | | | | | | | | O | | | | |

(continued)

| NO. | Example No | Heating layer and/or Conductive layer | | | | Insulating layer | | | | | | | |
| --- | --- | --- | --- | --- | --- | --- | --- | --- | --- | --- | --- | --- | --- |
| | | Printing Sequence | | Binder | | Coating Composition | | | | | | | |
| | | Conductive layer → Heating layer | Heating layer → Conductive layer | Acryl | Ure thane | Solvent-dispersion Polyurethane | | Solvent-dispersion Silicon A | | Solvent-dispersion Silicon B | | Liquid Silicon Rubber | |
| | | | | | | One Surface | Both Surfaces | One Surface | Both Surfaces | One Surface | Both Surfaces | One Surface | Both Surfaces |
| 38 | Comparati ve Example6 | | | | | | | | | O | | | |
| 39 | Comparati ve Example7 | | | | | | | | | | O | | |
| 40 | Comparati ve Example8 | | | | | | | | | | | O | |
| 41 | Comparati ve Example9 | | | | | | | | | | | | O |
| 42 | Comparati ve Example1 O | O | | O | | | | | | | | | |
| 43 | Comparati ve Example1 1 | O | | | O | | | | | | | | |
| 44 | Comparati ve Example 2 | | O | O | | | | | | | | | |
| 45 | Comparati ve Example1 3 | | O | | O | | | | | | | | |

EP 2 094 905 B1

**Test Results**

1. Measurement of resistance variation rate

In order to confirm insulation characteristic, the resistance variation rate was obtained by calculating the resistance value of before/after coating an insulating layer using Ohm meter.

Resistance variation rate = {(resistance value after coating resistance value before coating)/resistance value before coating} · 100

**TABLE 2**

| NO. | Example No. | Time | Resistance before coating} | Resistance after coating | (Before coating-After coating) Difference | Variation Resistance |
|---|---|---|---|---|---|---|
| | | | $\Omega$ | $\Omega$ | $\Omega$ | % |
| 1 | Example1 | 1 | 37.3 | 61.6 | 24.3 | 65.1 |
| | | 2 | 29.0 | 49.2 | 20.2 | 69.7 |
| | | 3 | 29.0 | 45.6 | 16.6 | 57.2 |
| 2 | Example3 | 1 | 22.4 | 31.5 | 9.1 | 40.6 |
| | | 2 | 33.0 | 54.0 | 21.0 | 63.6 |
| | | 3 | 40.4 | 79.0 | 38.6 | 95.5 |
| 3 | Example9 | 1 | 69.6 | 205.7 | 136.1 | 195.5 |
| | | 2 | 57.7 | 151.1 | 93.4 | 161.9 |
| | | 3 | 61.7 | 157.4 | 95.7 | 155.1 |
| | | 4 | 76.4 | 185.4 | 109.0 | 142.7 |
| | | 5 | 78.0 | 178.4 | 100.4 | 128.7 |
| | | 6 | 52.5 | 125.1 | 72.6 | 138.3 |
| | | 7 | 52.1 | 124.7 | 72.6 | 139.3 |
| | | 8 | 42.6 | 99.6 | 57.0 | 133.8 |
| | | 9 | 52.5 | 140.2 | 87.7 | 167.0 |
| | | 10 | 38.0 | 87.2 | 49.2 | 129.5 |
| 4 | Example11 | 1 | 64.9 | 171.9 | 107.0 | 164.9 |
| | | 2 | 66.8 | 182.1 | 115.3 | 172.6 |
| | | 3 | 64.8 | 177.0 | 112.2 | 173.1 |
| | | 4 | 67.7 | 186.6 | 118.9 | 175.6 |
| | | 5 | 64.5 | 174.8 | 110.3 | 171.0 |
| | | 6 | 53.6 | 120.1 | 66.5 | 124.1 |
| | | 7 | 50.0 | 115.5 | 65.5 | 131.0 |
| | | 8 | 55.6 | 137.4 | 81.8 | 147.1 |
| | | 9 | 54.2 | 122.9 | 68.7 | 126.8 |
| | | 10 | 49.3 | 115.5 | 66.2 | 134.3 |

(continued)

| NO. | Example No. | Time | Resistance before coating} | Resistance after coating | (Before coating-After coating) Difference | Variation Resistance |
|---|---|---|---|---|---|---|
| | | | Ω | Ω | Ω | % |
| 5 | Example17 | 1 | 44.6 | 140.6 | 96.0 | 215.2 |
| | | 2 | 44.2 | 133.3 | 89.1 | 201.6 |
| | | 3 | 47.5 | 162.9 | 115.4 | 242.9 |
| | | 4 | 49.9 | 173.4 | 123.5 | 247.5 |
| | | 5 | 48.0 | 176.9 | 128.9 | 268.5 |
| | | 6 | 42.4 | 119.6 | 77.2 | 182.1 |
| | | 7 | 39.4 | 120.2 | 80.8 | 205.1 |
| | | 8 | 40.1 | 115.5 | 75.4 | 188.0 |
| | | 9 | 39.0 | 114.3 | 75.3 | 193.1 |
| | | 10 | 41.3 | 132.8 | 91.5 | 221.5 |
| 6 | Example19 | 1 | 36.9 | 109.2 | 72.3 | 195.9 |
| | | 2 | 37.5 | 99.1 | 61.6 | 164.3 |
| | | 3 | 38.6 | 120.0 | 81.4 | 210.9 |
| | | 4 | 38.0 | 110.3 | 72.3 | 190.3 |
| | | 5 | 39.6 | 120.5 | 80.9 | 204.3 |
| | | 6 | 47.1 | 163.9 | 116.8 | 248.0 |
| | | 7 | 48.4 | 154.2 | 105.8 | 218.6 |
| | | 8 | 52.9 | 186.1 | 133.2 | 251.8 |
| | | 9 | 47.9 | 151.9 | 104.0 | 217.1 |
| | | 10 | 48.4 | 157.1 | 108.7 | 224.6 |
| 7 | Example25 | 1 | 50.5 | 49.1 | -1.4 | -2.8 |
| | | 2 | 52.8 | 51.6 | -1.2 | -2.3 |
| | | 3 | 56.5 | 55.2 | -1.3 | -2.3 |
| | | 4 | 51.5 | 50.5 | -1.0 | -1.9 |
| | | 5 | 55.8 | 54.2 | -1.6 | -2.9 |
| | | 6 | 53.2 | 52.5 | -0.7 | -1.3 |
| | | 7 | 59.8 | 58.1 | -1.7 | -2.8 |
| | | 8 | 56.0 | 55.1 | -0.9 | -1.6 |
| | | 9 | 57.4 | 56.3 | -1.1 | -1.9 |
| | | 10 | 50.3 | 45.6 | -4.7 | -9.3 |

(continued)

| NO. | Example No. | Time | Resistance before coating} | Resistance after coating | (Before coating-After coating) Difference | Variation Resistance |
|---|---|---|---|---|---|---|
| | | | Ω | Ω | Ω | % |
| 8 | Example27 | 1 | 51.0 | 52.2 | 1.2 | 2.4 |
| | | 2 | 49.1 | 50.6 | 1.5 | 3.1 |
| | | 3 | 53.7 | 54.4 | 0.7 | 1.3 |
| | | 4 | 58.5 | 63.5 | 5.0 | 8.5 |
| | | 5 | 49.8 | 58.4 | 8.6 | 17.3 |
| | | 6 | 71.6 | 95.4 | 23.8 | 33.2 |
| | | 7 | 75.5 | 89.0 | 13.5 | 17.9 |
| | | 8 | 77.6 | 98.7 | 21.1 | 27.2 |
| | | 9 | 62.7 | 78.6 | 15.9 | 25.4 |
| | | 10 | 72.5 | 85.2 | 12.7 | 17.5 |

As can be seen from Table 2, variations in the resistance of the insulating layer were large in coating the insulating layer with silicon (Examples 9 and 27) in particularly, solvent-dispersion silicon (Examples 9 and 19) rather than urethane (Examples. 1 and 3). Resistance as well as resistance variations was more increased in coating the insulating layer at both surfaces thereof than at one surface. In contrast, in case of coating liquid silicon rubber (Example 25), resistance in coating it at one surface of the insulating layer becomes low, whereas resistance in coating it at both surfaces of the insulating layer becomes increased minutely.

2. Measurement of tensile strength

* Test method (KSK 0520)

The average value is obtained by repeatedly measuring elongation and tensile strength of Examples and Comparative Examples at three times. In this case, a grip gap was 76mm, elongation speed was 5mm/min, load was 10KN (100kgf), temperature was 73F, and humidity was 50%. The test results of Examples and Comparative Examples is described in Table 3.

TABLE 3

| Example No. | Properties | Modulus | Tensile Strength | Elongation Distance Under Maximum Load | Stress Under Maximum Load | Strain Under Maximum Load |
|---|---|---|---|---|---|---|
| | Unit | (kgf/mm$^2$) | (kgf) | (mm) | (kgf/mm$^2$) | (mm/mm) |
| Example 5 | 1 | 633.979 | 41.53 | 27.45 | 163.504 | 0.361 |
| | 2 | 630.709 | 44.6 | 31.04 | 175.59 | 0.408 |
| | 3 | 601.614 | 44.38 | 30.95 | 174,724 | 0.407 |
| | Average | 622.1 | 43.503 | 29.813 | 171.273 | 0.392 |

(continued)

| Example No. | Properties | Modulus | Tensile Strength | Elongation Distance Under Maximum Load | Stress Under Maximum Load | Strain Under Maximum Load |
|---|---|---|---|---|---|---|
| | Unit | (kgf/mm$^2$) | (kgf) | (mm) | (kgf/mm$^2$) | (mm/mm) |
| Example 6 | 1 | 600.094 | 43.23 | 30.18 | 170.197 | 0.397 |
| | 2 | 609.582 | 43.68 | 31.28 | 171.968 | 0.412 |
| | 3 | 525.288 | 43.84 | 29.76 | 172.598 | 0.392 |
| | Average | 578.321 | 43.583 | 30.407 | 171.588 | 0.4 |
| Example 29 Example | 1 | 631.384 | 43.48 | 31.22 | 171.181 | 0.411 |
| | 2 | 321.09 | 41.1 | 29.07 | 161.811 | 0.383 |
| | 3 | 363.107 | 40.17 | 28.97 | 158.149 | 0.381 |
| | Average | 629.527 | 41.583 | 29.753 | 163.714 | 0.391 |
| Example 30 | 1 | 594.564 | 42.29 | 31.32 | 166.496 | 0.412 |
| | 2 | 583.463 | 39.33 | 29.04 | 154.842 | 0.382 |
| | 3 | 618.371 | 42.6 | 30.56 | 167.716 | 0.402 |
| | Average | 598.8 | 41.407 | 30.307 | 163.018 | 0.399 |
| Example 31 | 1 | 608.492 | 35.07 | 48.19 | 138.071 | 0.634 |
| | 2 | 575.294 | 27.56 | 30 | 108.504 | 0.396 |
| | 3 | 591.729 | 35.84 | 34.63 | 141.102 | 0.456 |
| | Average | 591.838 | 32.823 | 37.64 | 129.226 | 0.495 |
| Example 32 | 1 | 570.87 | 42.04 | 30.13 | 165512 | 0.396 |
| | 2 | 573.983 | 43.36 | 30.32 | 170.708 | 0.399 |
| | 3 | 575.556 | 42.46 | 30.17 | 167.765 | 0.397 |
| | Average | 573.47 | 42.62 | 30.207 | 167.795 | 0.397 |
| Comparative Example 1 | 1 | 652.348 | 41.45 | 29.28 | 163.189 | 0.385 |
| | 2 | 676.51 | 41.13 | 27.64 | 161.929 | 0.364 |
| | 3 | 0 | 0 | 0 | 0 | 0 |
| | Average | 664.429 | 41.29 | 28.46 | 162.559 | 0.374 |
| Comparative Example 8 | 1 | 570.87 | 42.04 | 30.13 | 165.512 | 0.396 |
| | 2 | 573.983 | 43.36 | 30.32 | 170.708 | 0.399 |
| | 3 | 575.556 | 42.46 | 30.17 | 167.165 | 0.397 |
| | Average | 573.47 | 42.62 | 30.207 | 167.795 | 0.397 |
| Comparative Example 9 | 1 | 547.762 | 41.52 | 47.56 | 163.464 | 0.626 |
| | 2 | 539.49 | 36.79 | 36.37 | 144.842 | 0.479 |
| | 3 | 569.719 | 40.46 | 44.51 | 159.291 | 0.586 |
| | Average | 552.323 | 39.59 | 42.813 | 155.866 | 0.563 |

(continued)

| Example No. | Properties | Modulus | Tensile Strength | Elongation Distance Under Maximum Load | Stress Under Maximum Load | Strain Under Maximum Load |
|---|---|---|---|---|---|---|
| | Unit | (kgf/mm$^2$) | (kgf) | (mm) | (kgf/mm$^2$) | (mm/mm) |
| Comparative Example 12 | 1 | 650.402 | 43.34 | 30.06 | 170.63 | 0.396 |
| | 2 | 642.483 | 39.95 | 27.44 | 157.283 | 0.361 |
| | 3 | 625.396 | 38.63 | 26.72 | 152.086 | 0.352 |
| | Average | 639.427 | 40.64 | 28.073 | 160 | 0.369 |
| Comparative Example 13 | 1 | 537.093 | 44.74 | 30.62 | 176.142 | 0.403 |
| | 2 | 626.95 | 40.79 | 27.44 | 160.59 | 0.361 |
| | 3 | 529.248 | 44.63 | 30.55 | 175.709 | 0.402 |
| | Average | 564.431 | 43.387 | 29.537 | 170.813 | 0.389 |

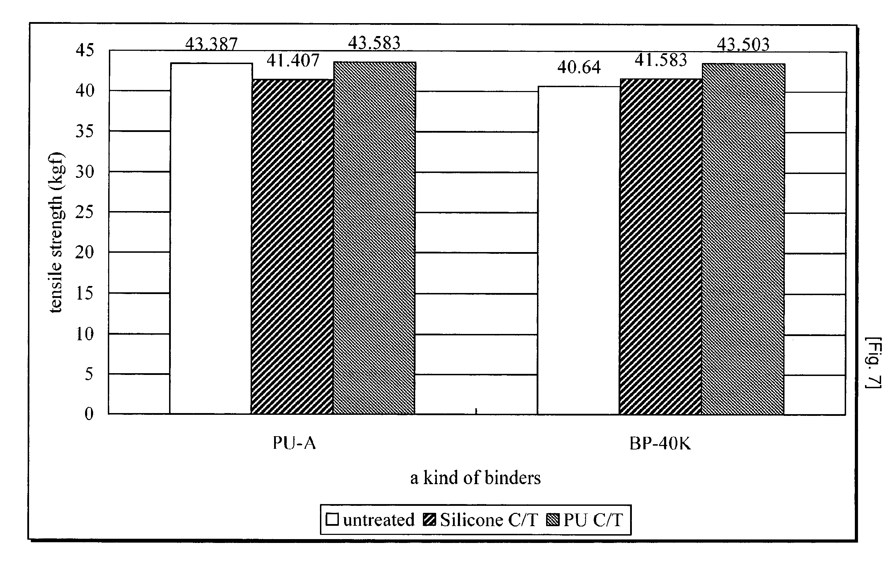

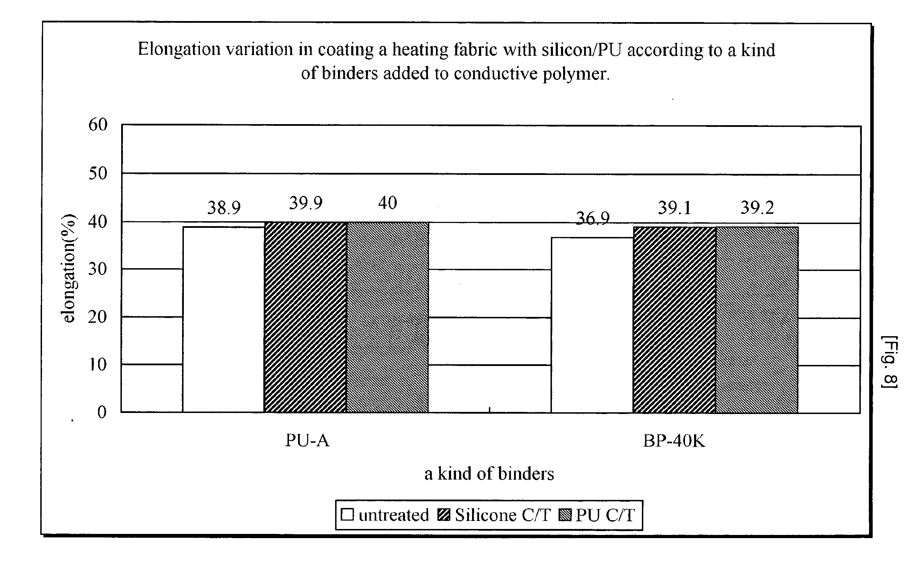

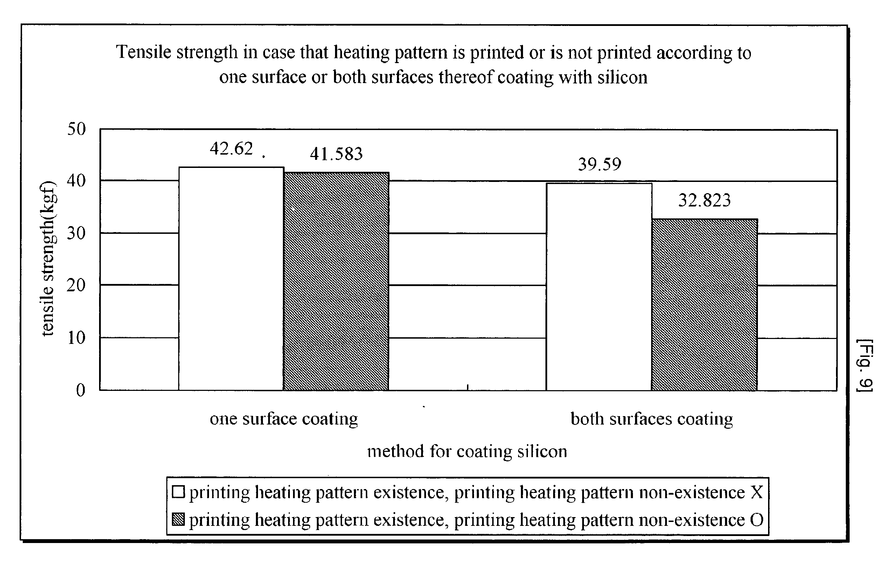

FIGs. 7 to 10 are graphs showing a change of tensile strength and elongation according to a kind of binders. FIG. 7 shows a change of elongation in coating silicon/ polyurethane according to a kind of binders added to conductive polymer. FIG. 8 shows a change of tensile strength in coating silicon/polyurethane according to a kind of binders added to conductive. FIG. 9 shows elongation of a heating fabric in case that heating pattern is printed or is not printed according to one surface or both surfaces thereof coating with silicon. In the above-mentioned graphs, "untreated" means that a heating pattern is printed, but is not coated. "silicon C/T" means that the heating pattern is printed and one surface thereof is coated with silicon resins. "PU C/T" means that the heating pattern is printed and one surface thereof is coated with polyurethane resins. "PU-A" means a polyurethane binder, and "AC-A" means an acrylic binder.

As shown in graphs, in aspect of elongation, the heating pattern coated with polyurethane in adding the polyurethane binder is similar to the heating pattern without coating. However, in case that heating pattern is coated with silicon, elongation becomes low. Additionally, the elongation of a heating pattern added with acrylic binder becomes increased after coating. In this case, after coating with silicon rather than polyurethane, the elongation is increased.

Meanwhile, tensile strength is increased irrespective of a kind of binders. This means that flexibility is also improved.

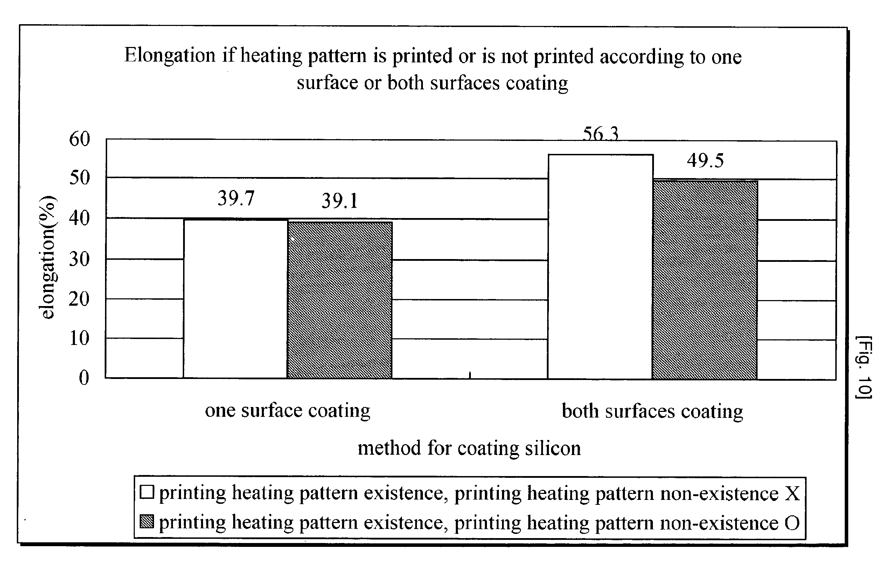

In FIGs. 9 and 10, "heating pattern O" means that conductive polymer and electrode are not printed, and coating process is not performed. "heating pattern X" means that conductive polymer (including acrylic binder) and electrode are printed and coating process is performed. In all cases of one or both surfaces coating, elongation becomes low when the heating pattern is printed. This means that fabrics are broken in spite of weak force owing to the printed heating pattern, and the fabrics are easily broken in coating fabrics at both surfaces thereof. In coating fabrics at both surfaces thereof, tensile strength is increased. When the heating pattern is printed, tensile strength is decreased.

3. Measurement of flex resistance

* Test method (KS K 0855: 2004, C method (Crumple/Flex method))

After sewing rectangle-shape coated fabrics in cylindrical shape, cylindrical-shaped samples are fabricated by dipping both ends of the coated fabrics in two disks faced each other. Then, one disk is tended to utilize torsion motion, and at the same time, the other disk is tended to utilize reciprocal motion in an axis-direction. After continuing torsion motion and reciprocal motion at 1,000 times, 5,000 times, and 10,000 times, resistance is measured.

In order to test durability in wearing clothes, resistance difference is checked after testing flex resistance according to the printing sequence of heating layer and conductive layer, and resistance difference before/after coating an insulating layer is tested.

TABLE 4

| NO. | Properties | 1,000 Times | | | 5,000 Times | | | 10,000 Times | | |
|---|---|---|---|---|---|---|---|---|---|---|
| | | Resistance before coating | Resistance after coating} | Resistance Variation | Resistance before coating} | Resistance after coating} | Resistance Variation | Resistance before coating | Resistance after coating} | Resistance Variation |
| | Unit | Ω | Ω | % | Ω | Ω | % | Ω | Ω | % |
| 1 | Example7 | 99.9 | 146.3 | 46.5 | 129.6 | 319.0 | 146.2 | 168.6 | 270.0 | 60.1 |
| 2 | Example19 | 125.0 | 265.5 | 112.4 | 181.0 | 291.5 | 61.1 | 156.6 | 615.0 | 292.7 |
| 3 | Example21 | 181.8 | 495.0 | 172.3 | 103.9 | 167.6 | 61.3 | 165.6 | 388.5 | 134.7 |
| 4 | Example23 | 219.5 | 642.5 | 192.8 | 268.8 | 742.5 | 176.3 | 194.8 | 386.0 | 98.2 |

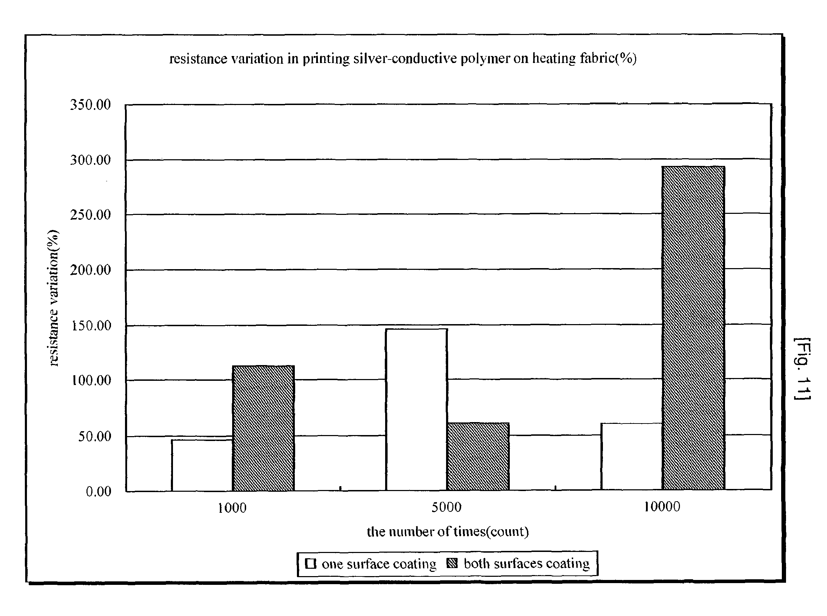

In case that the heating layer was printed after printing the conductive layer, resistance variation is relatively stable. As a rule, resistance variation is high in coating both surfaces of the heating layer and/or the conductive layer. FIGs. 10 to 11 are graphs showing the resistance variation according to the formation sequence of the heating layer and/or the conductive layer.

4. Measurement of wash Resistance

TABLES 5

| Washing frequency | Detergent | Dummy | Washing Condition | Drying Condition |
|---|---|---|---|---|
| 1 Time | Not included | Include | Wool course | High temperature & Dry |
| 2 Time | Not included | Not included | Wool course | High temperature & Dry |
| 3 Time | Not included | Not included | Wool course | Excluding hydration, Drying under 90°C/10min in oven |
| 4 Time | Neutral Detergent | Not included | Wool course | Excluding hydration, Drying under 90°C/10min in oven |

In the examples and comparative examples, the resistance of prepared samples is measured under the condition of Table 5.

$$\text{Resistance variation rate} = \{(\text{resistance value after washing resistance value before washing})/\text{resistance value after washing}\} \times 100$$

As shown in flowing Table 6, the many washing times are, the higher the resistance is. However, the resistance variation becomes low as compared to that before/after washing. In addition, resistance is low in coating one surface (Example 25) rather than coating both surfaces (Example 27). Accordingly, resistance rising is low even though washing times are increased, so that there is washing resistance.

**TABLE 6**

| Properties | Samples | After Coating (Ω) | Washing 1time (Ω) | Washing 2time (Ω) | Washing 3time (Ω) | Washing 4time (Ω) | Increament Afterwashing At1time(%) | Increament Afterwashing At2times (%) | Increament Afterwashing At3times (%) | Increament Afterwashing At4times (%) |
|---|---|---|---|---|---|---|---|---|---|---|
| | 1 | 26.3 | 37.0 | 45.8 | 58.7 | 59.3 | 40.7 | 23.8 | 28.2 | 1.0 |
| | 2 | 44.2 | 61.7 | 81.0 | 98.1 | 95.0 | 39.6 | 31.3 | 21.1 | -3.2 |
| | 3 | 43.1 | 56.7 | 87.4 | 100.3 | 104.0 | 31.6 | 54.1 | 14.8 | 3.7 |
| | 4 | 25.5 | 35.3 | 44.8 | 59.4 | 55.6 | 38.4 | 26.9 | 32.6 | -6.4 |
| | 5 | 45.1 | 52.4 | 72.3 | 92.4 | 91.3 | 16.2 | 38.0 | 27.8 | -1.2 |
| | 6 | 50.5 | 69.4 | 85.6 | 104.0 | 119.1 | 37.4 | 23.3 | 21.5 | 14.5 |
| | Average | 39.1 | 52.1 | 69.5 | 85.5 | 87.4 | - | - | - | - |
| | S.D | 10.6 | 13.6 | 19.4 | 20.8 | 25.1 | - | - | - | - |
| Example 25 | 1 | 29.5 | 49.1 | 62.0 | 68.1 | 69.2 | 66.4 | 26.3 | 9.8 | 1.6 |
| | 2 | 34.1 | 43.4 | 53.8 | 61.8 | 65.1 | 27.3 | 24.0 | 14.9 | 5.3 |
| | 3 | 34.8 | 44.8 | 49.0 | 60.3 | 65.2 | 28.7 | 9.4 | 23.1 | 8.1 |
| | 4 | 28.0 | 40.9 | 46.6 | 64.3 | 67.4 | 46.1 | 13.9 | 38.0 | 4.8 |
| | 5 | 36.7 | 58.8 | 72.1 | 89.1 | 104.0 | 60.2 | 22.6 | 23.6 | 16.7 |
| | 6 | 35.2 | 61.9 | 66.6 | 80.1 | 85.6 | 75.9 | 7.6 | 20.3 | 6.9 |
| | Average | 33.1 | 49.8 | 58.4 | 70.6 | 76.1 | - | - | - | - |
| | S.D | 3.5 | 8.6 | 10.2 | 11.5 | 15.7 | - | - | - | - |

| Properties | Samples | After Coating (Ω) | Washing 1time (Ω) | Washing 2time (Ω) | Washing 3time (Ω) | Washing 4time (Ω) | Increament Afterwashing At1time(%) | Increament Afterwashing At2times (%) | Increament Afterwashing At3times (%) | Increament Afterwashing At4times (%) |
|---|---|---|---|---|---|---|---|---|---|---|
| Example 27 | 1 | 36.6 | 55.3 | 64.0 | 72.5 | 78.9 | 51.1 | 15.7 | 13.3 | 8.8 |
| | 2 | 35.7 | 47.4 | 51.3 | 58.7 | 66.7 | 32.8 | 8.2 | 14.4 | 13.6 |
| | 3 | 33.2 | 44.7 | 54.9 | 68.4 | 63.3 | 34.6 | 22.8 | 24.6 | -7.5 |
| | 4 | 47.5 | 67.0 | 89.2 | 89.8 | 93.5 | 41.1 | 33.1 | 0.7 | 4.1 |
| | 5 | 35.1 | 45.1 | 57.4 | 68.5 | 68.0 | 28.5 | 27.3 | 19.3 | -0.7 |
| | 6 | 33.5 | 48.6 | 69.8 | 83.0 | 84.3 | 45.1 | 43.6 | 18.9 | 1.6 |
| | Average | 36.9 | 51.4 | 64.4 | 73.5 | 75.8 | - | - | - | - |
| | S.D | 5.3 | 8.6 | 13.8 | 11.2 | 11.8 | - | - | - | - |
| | 1 | 20.5 | 33.9 | 33.7 | 34.6 | 39.0 | 65.4 | -0.6 | 2.7 | 12.7 |
| | 2 | 22.4 | 30.6 | 31.7 | 32.1 | 34.3 | 36.6 | 3.6 | 1.3 | 6.9 |
| | 3 | 23.3 | 32.8 | 34.7 | 39.1 | 41.8 | 40.8 | 5.8 | 12.7 | 6.9 |
| | 4 | 23.4 | 34.4 | 32.5 | 33.5 | 36.8 | 47.0 | -5.5 | 3.1 | 9.9 |
| | 5 | 24.8 | 33.1 | 33.5 | 36.5 | 39.4 | 33.5 | 1.2 | 9.0 | 7.9 |
| | 6 | 27.0 | 34.5 | 35.5 | 40.5 | 40.5 | 27.8 | 2.9 | 14.1 | 0.0 |
| | Average | 23.6 | 33.2 | 33.6 | 36.1 | 38.6 | - | - | - | - |
| | S.D | 2.2 | 1.5 | 1.4 | 3.3 | 2.7 | - | - | - | - |

EP 2 094 905 B1

Although the present invention has been described herein with reference to the foregoing embodiments and the accompanying drawings, the scope of the present invention is defined by the claims that follow. Accordingly, those skilled in the art will appreciate that various substitutions, modifications and changes are possible, within the scope of the present invention as disclosed in the accompanying claims. It is to be understood that such substitutions, modifications and changes are within the scope of the present invention.

Particularly, it should, of course, be understood that the conductive fabric of the present invention can be used as a circuit board or a part of an electronic device although smart wear only has been mentioned throughout the specification.

**Claims**

1. A heating fabric comprising a base layer (100) composed of a synthetic, regenerated or natural fiber and an insulating layer (500), comprising
a primer layer (200) formed on the base layer (100) to make the surface of the base layer uniform;
a heating layer (300) formed on the primer layer (200)
a conductive layer (400) with a pre-designed electric pattern wholly or partially in contact with the heating layer (300) on an upper surface, a lower surface, or the same surface thereof as a line or a surface; wherein
the insulating layer (500) is formed on or upper the conductive layer (400) and the heating layer (300), the primer layer (200) is formed of a multi-layered layer together with a water-repellent layer.

2. The heating fabric according to claim 1, wherein the primer layer (200) is formed of at least one resin selected from the group consisting of polyurethane, acrylic and silicone resins.

3. The heating fabric according to claim 1, wherein the heating layer (300) or the conductive layer (400) is formed of a conductive material or a mixture thereof with a binder.

4. The heating fabric according to claim 3, wherein the conductive material is formed of at least one selected from the group consisting of conductive polymer, carbon, silver, gold, platinum, palladium, copper, aluminum, tartar, iron, and nickel.

5. The heating fabric according to claim 3, wherein the binder is formed of at least one selected from the group consisting of polyurethane resins, acrylic resins, silicone resins, melamine resins, epoxy resins, and mixtures thereof

6. The heating fabric according to claim 5, wherein the binder is formed of water dispersed-polyurethane.

7. The heating fabric according to claim 4, wherein the conductive polymer is selected from the group consisting of polyaniline, polypyrrole, polythiophene, and mixtures thereof.

8. The heating fabric according to claim 3, wherein the conductive material and the binder are mixed in a weight ratio of 90:10 to 80:20 to form the conductive layer.

9. The heating fabric according to claim 1, wherein the conductive layer (400) and the heating layer (300) are in contact at two or more points.

10. The heating fabric according to claim 1, wherein the conductive layer (400) or the heating layer (300) have a thickness of 2 mm to 500 mm.

11. The heating fabric according to claim 1, wherein the conductive layer (400) has a width of 10 mm to 20 mm.

12. The heating fabric according to claim 1, wherein the insulating layer (500) is formed by coating, printing or laminating at least one resin selected from the group consisting of polyurethane, acrylic, silicone, polyester, polyvinyl chloride (PVC) and polytetrafluoroethylene (PTFE) resins.

13. The heating fabric according to claim 1, wherein the conductive layer (400) has the enlarged portions (450) of bent portions (430) of a circuit whose width is larger than that of linear portions (410) of the circuit.

14. The heating fabric according to claim 13, wherein the enlarged portions (450) have a circular or oval shape.

**15.** The heating fabric according to claim 1, wherein the heating fabric (10) has a resistance difference of 0.5 $\Omega$ to 4 $\Omega$ before and after washing.

**16.** A method for fabricating a heating fabric, comprising, in the following order, the steps of forming a primer layer (200) on a base layer (100) composed of a synthetic, regenerated or natural fiber in order to maintain the thickness of a conductive layer (400) and a heating layer (300) at a constant level before forming the conductive layer (400) and the heating layer (300), wherein said primer layer (200) is formed of a multi-layered layer together with a water-repellent layer;

forming the heating layer (300) on the primer layer (200);

forming the conductive layer (400) wholly or partially in contact with the heating layer (300) on an upper surface, a lower surface, or the same surface thereof as a line or a surface; and forming an insulating layer (500) on or upper the conductive layer (400) and the heating layer (300) for electric shield.

**17.** A method for fabricating a heating fabric, comprising, in the following order, the steps of forming a primer layer (200) on a base layer (100) composed of a synthetic, regenerated or natural fiber in order to maintain the thickness of a conductive layer (400) and a heating layer (300) at a constant level before forming the conductive layer (400) and the heating layer (300), wherein said primer layer (200) is formed of a multi-layered layer together with a water-repellent layer;

forming the conductive layer (400) on the primer layer (200);

forming the heating layer (300) wholly or partially in contact with the conductive layer (400) on an upper surface, a lower surface, or the same surface of the heating layer as a line or a surface; and

forming an insulating layer (500) on the conductive layer (400) and the heating layer (300) for electric shield.

**18.** A method for fabricating a heating fabric comprising:

forming a primer layer (200) on a base layer (100) composed of a synthetic, regenerated or natural fiber in order to maintain the thickness of a conductive layer (400) and a heating layer (300) at a constant level before forming the conductive layer (400) and the heating layer (300), wherein said primer layer (200) is formed of a multi-layered layer together with a water-repellent layer;

simultaneously forming the conductive layer (400) and the heating layer (300) on the primer layer (200); and then forming an insulating layer (500) on the conductive layer (400) and the heating layer (300) for electric shield.

**19.** The method according to any one of claims 16 to 18, further comprising calendering the base layer (100) using a pressing roller before the formation of the conductive layer (400) to make the surface of the base layer (100) smooth, offset pores of the base layer (100) and enhance the flex resistance of the conductive fabric (10).

**20.** The method according to claim 19, wherein the primer layer (200) is formed by knife rolling, over roll coating, floating knife coating, or knife over roll coating, laminating, printing, or gravure printing.

**21.** The method according to claim 19, wherein the primer layer (200) is selected from the group consisting of polyurethane resins, acrylic resins, and silicone resins.

**22.** The method according to any one of claims 16 to 18, further comprising moisture water proofing/water proofing to enhance insulation, water fastness, and the flex resistance of the conductive fabric (10).

**23.** The method according to any one of claims 16 to 18, wherein the heating layer (300) or the conductive layer (400) are coated by at least one selected from the group consisting of coating, printing, and transfer-style printing.

**24.** The method according to any one of claims 16 to 18, wherein the heating layer (300) or the conductive layer (400) is formed of at least one material selected from the group consisting of a conductive material and a mixture thereof with a binder.

**25.** The method according to claim 24, wherein the conductive material is formed of at least one selected from the group consisting of conductive polymer, carbon, silver, gold, platinum, palladium, copper, aluminum, tartar, iron, and nickel.

**26.** The method according to claim 24, wherein the binder is formed of at least one selected from the group consisting of polyurethane resins, acrylic resins, silicone resins, melamine resins, epoxy resins, and mixtures thereof.

27. The method according to claim 26, wherein the binder is formed of water dispersed-polyurethane.

28. The method according to claim 25, wherein the conductive polymer is selected from the group consisting of polyaniline, polypyrrole, polythiophene, and mixtures thereof.

29. The method according to claim 25, wherein the conductive material and the binder are mixed in a weight ratio of 90:10 to 80:20 to form the conductive layer.

30. The method according to any one of claim 16 to 18, wherein the conductive layer (400) and the heating layer (300) are in contact at two or more points.

31. The heating fabric according to any one of claim 16 to 18, wherein the conductive layer (400) or the heating layer (300) have a thickness of 2 mm to 500 mm.

32. The heating fabric according to any one of claim 16 to 18, wherein the conductive layer (400) has a width of 10 mm to 20 mm.

33. The heating fabric according to any one of claim 16 to 18, wherein the insulating layer (500) is formed by coating, printing or laminating at least one resin selected from the group consisting of polyurethane, acrylic, silicone, polyester, polyvinyl chloride (PVC) and polytetrafluoroethylene (PTFE) resins on the conductive layer.

34. The heating fabric according to any one of claim 16 to 18, wherein the insulating layer (500) is formed by drying in case of direct coating or hot-melt dot or gravure in case of laminating.

35. The method according to any one of claim 16 to 18, wherein the conductive layer (400) has the enlarged portions (450) of bent portions (430) of a circuit whose width is larger than that of linear portions (410) of the circuit.

36. The method according to claim 35, wherein the enlarged portions (450) have a circular or oval shape.

37. The method according to any one of claim 16 to 18, wherein the heating fabric (10) has a resistance difference of 0.5 Ω to 4 Ω before and after washing.

**Patentansprüche**

1. Heizgewebe umfassend eine aus einer Synthese-, Regenerat- oder Naturfaser bestehende Basisschicht (100) und eine Isolierschicht (500), umfassend
   eine auf der Basisschicht (100) gebildete Grundierungsschicht (200), um die Oberfläche der Basisschicht gleichmäßig zu machen;
   eine auf der Grundierungsschicht (200) gebildete Heizschicht (300);
   eine Leitschicht (400) mit einem vorkonstruierten elektrischen Muster, die als Linie oder Oberfläche ganz oder teilweise in Kontakt mit der Heizschicht (300) auf einer oberen Oberfläche, einer unteren Oberfläche oder der gleichen Oberfläche davon ist; wobei
   die Isolierschicht (500) auf oder über der Leitschicht (400) und der Heizschicht (300) gebildet ist und die Grundierungsschicht (200) aus einer mehrlagigen Schicht zusammen mit einer wasserabweisenden Schicht gebildet ist.

2. Heizgewebe nach Anspruch 1, wobei die Grundierungsschicht (200) aus mindestens einem Harz, das aus der Gruppe bestehend aus Polyurethan-, Acryl- und Silikonharzen ausgewählt ist, gebildet ist.

3. Heizgewebe nach Anspruch 1, wobei die Heizschicht (300) oder die Leitschicht (400) aus einem leitfähigen Material oder einer Mischung davon mit einem Bindemittel gebildet ist.

4. Heizgewebe nach Anspruch 3, wobei das leitfähige Material aus mindestens einem, das aus der Gruppe bestehend aus leitfähigem Polymer, Kohlenstoff, Silber, Gold, Platin, Palladium, Kupfer, Aluminium, Weinstein, Eisen und Nickel ausgewählt ist, gebildet ist.

5. Heizgewebe nach Anspruch 3, wobei das Bindemittel aus mindestens einem, das aus der Gruppe bestehend aus Polyurethanharzen, Acrylharzen, Silikonharzen, Melaminharzen, Epoxidharzen und Mischungen davon ausgewählt ist, gebildet ist.

6. Heizgewebe nach Anspruch 5, wobei das Bindemittel aus in Wasser dispergiertem Polyurethan gebildet ist.

7. Heizgewebe nach Anspruch 4, wobei das leitfähige Polymer aus der Gruppe bestehend aus Polyanilin, Polypyrrol, Polythiopen und Mischungen davon ausgewählt ist.

8. Heizgewebe nach Anspruch 3, wobei das leitfähige Material und das Bindemittel in einem Gewichtsverhältnis von 90:10 bis 80:20 gemischt sind, um die Leitschicht zu bilden.

9. Heizgewebe nach Anspruch 1, wobei die Leitschicht (400) und die Heizschicht (300) an zwei oder mehr Stellen in Kontakt sind.

10. Heizgewebe nach Anspruch 1, wobei die Leitschicht (400) oder die Heizschicht (300) eine Dicke von 2 mm bis 500 mm aufweist.

11. Heizgewebe nach Anspruch 1, wobei die Leitschicht (400) eine Breite von 10 mm bis 20 mm aufweist.

12. Heizgewebe nach Anspruch 1, wobei die Isolierschicht (500) durch Beschichten, Aufdrucken oder Auflaminieren von mindestens einem Harz, das aus der Gruppe bestehend aus Polyurethan-, Acryl-, Silikon-, Polyester-, Polyvinylchlorid- (PVC-) und Polytetrafluorethylen- (PTFE-) - Harzen ausgewählt ist, gebildet ist.

13. Heizgewebe nach Anspruch 1, wobei die Leitschicht (400) die vergrößerten Abschnitte (450) von gebogenen Abschnitten (430) einer Schaltung aufweist, deren Breite größer als diejenige von geraden Abschnitten (410) der Schaltung ist.

14. Heizgewebe nach Anspruch 13, wobei die vergrößerten Abschnitte (450) eine Kreis- oder Ovalform aufweisen.

15. Heizgewebe nach Anspruch 1, wobei das Heizgewebe (10) eine Widerstandsdifferenz von 0,5 $\Omega$ bis 4 $\Omega$ vor und nach dem Waschen aufweist.

16. Verfahren zur Herstellung eines Heizgewebes, umfassend, in der folgenden Reihenfolge, die Schritte zum
Bilden einer Grundierungsschicht (200) auf einer aus einer Synthese-, Regenerat- oder Naturfaser bestehenden Basisschicht (100), um die Dicke einer Leitschicht (400) und einer Heizschicht (300) vor dem Bilden der Leitschicht (400) und der Heizschicht (300) bei einer gleichmäßigen Höhe zu halten, wobei die Grundierungsschicht (200) aus einer mehrlagigen Schicht zusammen mit einer wasserabweisenden Schicht gebildet wird;
Bilden der Heizschicht (300) auf der Grundierungsschicht (200);
Bilden der Leitschicht (400), die als Linie oder Oberfläche ganz oder teilweise in Kontakt mit der Heizschicht (300) auf einer oberen Oberfläche, einer unteren Oberfläche oder der gleichen Oberfläche davon ist; und
Bilden einer Isolierschicht (500) auf oder über der Leitschicht (400) und der Heizschicht (300) zur elektrischen Abschirmung.

17. Verfahren zur Herstellung eines Heizgewebes, umfassend, in der folgenden Reihenfolge, die Schritte zum
Bilden einer Grundierungsschicht (200) auf einer aus einer Synthese-, Regenerat- oder Naturfaser bestehenden Basisschicht (100), um die Dicke einer Leitschicht (400) und einer Heizschicht (300) vor dem Bilden der Leitschicht (400) und der Heizschicht (300) bei einer gleichmäßigen Höhe zu halten, wobei die Grundierungsschicht (200) aus einer mehrlagigen Schicht zusammen mit einer wasserabweisenden Schicht gebildet wird;
Bilden der Leitschicht (400) auf der Grundierungsschicht (200);
Bilden der Heizschicht (300), die als Linie oder Oberfläche ganz oder teilweise in Kontakt mit der Leitschicht (400) auf einer oberen Oberfläche, einer unteren Oberfläche oder der gleichen Oberfläche der Heizschicht ist; und
Bilden einer Isolierschicht (500) auf der Leitschicht (400) und der Heizschicht (300) zur elektrischen Abschirmung.

18. Verfahren zur Herstellung eines Heizgewebes, umfassend:

Bilden einer Grundierungsschicht (200) auf einer aus einer Synthese-, Regenerat- oder Naturfaser bestehenden Basisschicht (100), um die Dicke einer Leitschicht (400) und einer Heizschicht (300) vor dem Bilden der Leitschicht (400) und der Heizschicht (300) bei einer gleichmäßigen Höhe zu halten, wobei die Grundierungsschicht (200) aus einer mehrlagigen Schicht zusammen mit einer wasserabweisenden Schicht gebildet wird;

gleichzeitiges Bilden der Leitschicht (400) und der Heizschicht (300) auf der Grundierungsschicht (200); und dann

Bilden einer Isolierschicht (500) auf der Leitschicht (400) und der Heizschicht (300) zur elektrischen Abschirmung.

**19.** Verfahren nach irgendeinem der Ansprüche 16 bis 18, ferner umfassend das Kalandrieren der Basisschicht (100) unter Verwendung einer Anpresswalze vor der Bildung der Leitschicht (400), um die Oberfläche der Basisschicht (100) glatt zu machen, Poren der Basisschicht (100) auszugleichen und die Biegefestigkeit des leitfähigen Gewebes (10) zu verbessern.

**20.** Verfahren nach Anspruch 19, wobei die Grundierungsschicht (200) durch Walzen mit Rakel, Walzenbeschichtung, Beschichtung mit Luftrakel oder Beschichtung mit Walzenrakel, Laminieren, Druck oder Tiefdruck gebildet wird.

**21.** Verfahren nach Anspruch 19, wobei die Grundierungsschicht (200) aus der Gruppe bestehend aus Polyurethanharzen, Acrylharzen und Silikonharzen ausgewählt ist.

**22.** Verfahren nach irgendeinem der Ansprüche 16 bis 18, ferner umfassend das Imprägnieren gegen Feuchtigkeit / Imprägnieren gegen Wasser, um die Isolierung, Wasserechtheit und Biegefestigkeit des leitfähigen Gewebes (10) zu verbessern.

**23.** Verfahren nach irgendeinem der Ansprüche 16 bis 18, wobei die Heizschicht (300) oder die Leitschicht (400) durch mindestens eines, das aus der Gruppe bestehend aus Beschichten, Druck und Transferdruck ausgewählt ist, beschichtet wird.

**24.** Verfahren nach irgendeinem der Ansprüche 16 bis 18, wobei die Heizschicht (300) oder die Leitschicht (400) aus mindestens einem Material, das aus der Gruppe bestehend aus leitfähigem Material und einer Mischung davon mit einem Bindemittel ausgewählt ist, gebildet wird.

**25.** Verfahren nach Anspruch 24, wobei das leitfähige Material aus mindestens einem, das aus der Gruppe bestehend aus leitfähigem Polymer, Kohlenstoff, Silber, Gold, Platin, Palladium, Kupfer, Aluminium, Weinstein, Eisen und Nickel ausgewählt ist, gebildet wird.

**26.** Verfahren nach Anspruch 24, wobei das Bindemittel aus mindestens einem, das aus der Gruppe bestehend aus Polyurethanharzen, Acrylharzen, Silikonharzen, Melaminharzen, Epoxidharzen und Mischungen davon ausgewählt ist, gebildet wird.

**27.** Verfahren nach Anspruch 26, wobei das Bindemittel aus in Wasser dispergiertem Polyurethan gebildet wird.

**28.** Verfahren nach Anspruch 25, wobei das leitfähige Polymer aus der Gruppe bestehend aus Polyanilin, Polypyrrol, Polythiopen und Mischungen davon ausgewählt ist.

**29.** Verfahren nach Anspruch 25, wobei das leitfähige Material und das Bindemittel in einem Gewichtsverhältnis von 90:10 bis 80:20 gemischt werden, um die Leitschicht zu bilden.

**30.** Verfahren nach irgendeinem der Ansprüche 16 bis 18, wobei die Leitschicht (400) und die Heizschicht (300) an zwei oder mehr Stellen in Kontakt sind.

**31.** Heizgewebe nach irgendeinem der Ansprüche 16 bis 18, wobei die Leitschicht (400) oder die Heizschicht (300) eine Dicke von 2 mm bis 500 mm aufweist.

**32.** Heizgewebe nach irgendeinem der Ansprüche 16 bis 18, wobei die Leitschicht (400) eine Breite von 10 mm bis 20 mm aufweist.

**33.** Heizgewebe nach irgendeinem der Ansprüche 16 bis 18, wobei die Isolierschicht (500) durch Beschichten, Aufdrucken oder Auflaminieren von mindestens einem Harz, das aus der Gruppe bestehend aus Polyurethan-, Acryl-, Silikon-, Polyester-, Polyvinylchlorid- (PVC-) und Polytetrafluorethylen- (PTFE-) -Harzen ausgewählt ist, auf der Leitschicht gebildet ist.

**34.** Heizgewebe nach irgendeinem der Ansprüche 16 bis 18, wobei die Isolierschicht (500) durch Trocknen im Falle des Direktbeschichtens oder Heißschmelz-Punktlaminieren oder Tiefdruck im Falle des Laminierens gebildet ist.

**35.** Verfahren nach irgendeinem der Ansprüche 16 bis 18, wobei die Leitschicht (400) die vergrößerten Abschnitte (450) von gebogenen Abschnitten (430) einer Schaltung aufweist, deren Breite größer als diejenige von geraden Abschnitten (410) der Schaltung ist.

**36.** Verfahren nach Anspruch 35, wobei die vergrößerten Abschnitte (450) eine Kreis- oder Ovalform aufweisen.

**37.** Verfahren nach irgendeinem der Ansprüche 16 bis 18, wobei das Heizgewebe (10) eine Widerstandsdifferenz von 0,5 Ω bis 4 Ω vor und nach dem Waschen aufweist.


## Revendications

**1.** Étoffe chauffante comprenant une couche de base (100) composée
d'une fibre synthétique, régénérée ou naturelle et une couche d'isolation (500), comprenant une couche d'apprêt (200) formée sur la couche de base (100) pour rendre la surface de la couche de base uniforme;
une couche chauffante (300) formée sur la couche d'apprêt (200) ;
une couche conductrice (400) avec un motif électrique préconçu totalement ou partiellement en contact avec la couche chauffante (300) sur une surface supérieure, une surface inférieure, ou la même surface de celle-ci comme une ligne ou une surface; dans laquelle
la couche d'isolation (500) est formée sur ou par-dessus la couche conductrice (400) et la couche chauffante (300),
la couche d'apprêt (200) est formée d'une couche multicouches avec une couche hydrophobe.

**2.** Étoffe chauffante selon la revendication 1, dans laquelle la couche d'apprêt (200) est formée d'au moins une résine choisie parmi le groupe consistant en des résines de polyuréthane, acryliques et de silicone.

**3.** Étoffe chauffante selon la revendication 1, dans laquelle la couche chauffante (300) ou la couche conductrice (400) est formée d'un matériau conducteur ou d'un mélange de celui-ci avec un liant.

**4.** Étoffe chauffante selon la revendication 3, dans laquelle le matériau conducteur est formé d'au moins un choisi parmi le groupe consistant en un polymère conducteur, le carbone, l'argent, l'or, le platine, le palladium, le cuivre, l'aluminium, le tartre, le fer, et le nickel.

**5.** Étoffe chauffante selon la revendication 3, dans laquelle le liant est formé d'au moins un choisi parmi le groupe consistant en des résines de polyuréthane, des résines acryliques, des résines de silicone, des résines de mélamine, des résines époxy, et des mélanges de celles-ci.

**6.** Étoffe chauffante selon la revendication 5, dans laquelle le liant est formé d'un polyuréthane dispersé dans l'eau.

**7.** Étoffe chauffante selon la revendication 4, dans laquelle le polymère conducteur est choisi parmi le groupe consistant en une polyaniline, un polypyrrole, un polythiophène, et des mélanges de ceux-ci.

**8.** Étoffe chauffante selon la revendication 3, dans laquelle le matériau conducteur et le liant sont mélangés à hauteur d'un rapport en poids de 90:10 à 80:20 pour former la couche conductrice.

**9.** Étoffe chauffante selon la revendication 1, dans laquelle la couche conductrice (400) et la couche chauffante (300) sont en contact en deux points ou plus.

**10.** Étoffe chauffante selon la revendication 1, dans laquelle la couche conductrice (400) ou la couche chauffante (300) a une épaisseur de 2 mm à 500 mm.

**11.** Étoffe chauffante selon la revendication 1, dans laquelle la couche conductrice (400) a une largeur de 10 mm à 20 mm.

**12.** Étoffe chauffante selon la revendication 1, dans laquelle la couche d'isolation (500) est formée par enduction, impression ou stratification d'au moins une résine choisie parmi le groupe consistant en des résines de polyuréthane, acryliques, de silicone, de polyester, de poly(chlorure de vinyle) (PVC) et de polytétrafluoroéthylène (PTFE).

13. Étoffe chauffante selon la revendication 1, dans laquelle la couche conductrice (400) a les parties élargies (450) de parties courbes (430) d'un circuit dont la largeur est plus grande que celle de parties linéaires (410) du circuit.

14. Étoffe chauffante selon la revendication 13, dans laquelle les parties élargies (450) ont une forme circulaire ou ovale.

15. Étoffe chauffante selon la revendication 1, dans laquelle l'étoffe chauffante (10) a une différence de résistance de 0,5 Ω à 4 Ω avant et après lavage.

16. Procédé de fabrication d'une étoffe chauffante, comprenant, dans l'ordre suivant, les étapes de
formation d'une couche d'apprêt (200) sur une couche de base (100) composée d'une fibre synthétique, régénérée ou naturelle afin de maintenir l'épaisseur d'une couche conductrice (400) et d'une couche chauffante (300) à un niveau constant avant la formation de la couche conductrice (400) et de la couche chauffante (300), dans lequel ladite couche d'apprêt (200) est formée d'une couche multicouches avec une couche hydrophobe ;
formation de la couche chauffante (300) sur la couche d'apprêt (200) ;
formation de la couche conductrice (400) totalement ou partiellement en contact avec la couche chauffante (300) sur une surface supérieure, une surface inférieure, ou la même surface de celle-ci comme une ligne ou une surface; et formation d'une couche d'isolation (500) sur ou par-dessus la couche conductrice (400) et la couche chauffante (300) pour une protection électrique.

17. Procédé de fabrication d'une étoffe chauffante, comprenant, dans l'ordre suivant, les étapes de
formation d'une couche d'apprêt (200) sur une couche de base (100) composée d'une fibre synthétique, régénérée ou naturelle afin de maintenir l'épaisseur d'une couche conductrice (400) et d'une couche chauffante (300) à un niveau constant avant la formation de la couche conductrice (400) et de la couche chauffante (300), dans lequel ladite couche d'apprêt (200) est formée d'une couche multicouches avec une couche hydrophobe ;
formation de la couche conductrice (400) sur la couche d'apprêt (200) ; formation de la couche chauffante (300) totalement ou partiellement en contact avec la couche conductrice (400) sur une surface supérieure, une surface inférieure, ou la même surface de la couche chauffante comme une ligne ou une surface ; et
formation d'une couche d'isolation (500) sur la couche conductrice (400) et la couche chauffante (300) pour une protection électrique.

18. Procédé de fabrication d'une étoffe chauffante, comprenant :

la formation d'une couche d'apprêt (200) sur une couche de base (100) composée d'une fibre synthétique, régénérée ou naturelle afin de maintenir l'épaisseur d'une couche conductrice (400) et d'une couche chauffante (300) à un niveau constant avant la formation de la couche conductrice (400) et de la couche chauffante (300), dans lequel ladite couche d'apprêt (200) est formée d'une couche multicouches avec une couche hydrophobe ;
la formation simultanée de la couche conductrice (400) et de la couche chauffante (300) sur la couche d'apprêt (200) ; et ensuite
la formation d'une couche d'isolation (500) sur la couche conductrice (400) et la couche chauffante (300) pour une protection électrique.

19. Procédé selon l'une quelconque des revendications 16 à 18, comprenant en outre le calandrage de la couche de base (100) en utilisant un cylindre presseur avant la formation de la couche conductrice (400) pour rendre la surface de la couche de base (100) lisse, combler les pores de la couche de base (100) et améliorer la résistance à la flexion de l'étoffe conductrice (10).

20. Procédé selon la revendication 19, dans lequel la couche d'apprêt (200) est formée par roulage à la racle, enduction sur cylindre, enduction à la racle flottante, ou enduction à la racle sur cylindre, stratification, impression, ou impression par gravure.

21. Procédé selon la revendication 19, dans lequel la couche d'apprêt (200) est choisie parmi le groupe consistant en des résines de polyuréthane, des résines acryliques et des résines de silicone.

22. Procédé selon l'une quelconque des revendications 16 à 18, comprenant en outre une imperméabilisation à l'humidité/imperméabilisation à l'eau pour améliorer une isolation, une tenue à l'eau, et la résistance à la flexion de l'étoffe conductrice (10).

23. Procédé selon l'une quelconque des revendications 16 à 18, dans lequel la couche chauffante (300) ou la couche conductrice (400) est déposée par au moins une choisie parmi le groupe consistant en une enduction, une impression, et une impression de type par transfert.

**24.** Procédé selon l'une quelconque des revendications 16 à 18, dans lequel la couche chauffante (300) ou la couche conductrice (400) est formée d'au moins un matériau choisi parmi le groupe consistant en un matériau conducteur et un mélange de celui-ci avec un liant.

**25.** Procédé selon la revendication 24, dans lequel le matériau conducteur est formé d'au moins un choisi parmi le groupe consistant en un polymère conducteur, le carbone, l'argent, l'or, le platine, le palladium, le cuivre, l'aluminium, le tartre, le fer, et le nickel.

**26.** Procédé selon la revendication 24, dans lequel le liant est formé d'au moins un choisi parmi le groupe consistant en des résines de polyuréthane, des résines acryliques, des résines de silicone, des résines de mélamine, des résines époxy, et des mélanges de celles-ci.

**27.** Procédé selon la revendication 26, dans lequel le liant est formé d'un polyuréthane dispersé dans l'eau.

**28.** Procédé selon la revendication 25, dans lequel le polymère conducteur est choisi parmi le groupe consistant en une polyaniline, un polypyrrole, un polythiophène, et des mélanges de ceux-ci.

**29.** Procédé selon la revendication 25, dans lequel le matériau conducteur et le liant sont mélangés à hauteur d'un rapport en poids de 90:10 à 80:20 pour former la couche conductrice.

**30.** Procédé selon l'une quelconque des revendications 16 à 18, dans lequel la couche conductrice (400) et la couche chauffante (300) sont en contact en deux points ou plus.

**31.** Étoffe chauffante selon l'une quelconque des revendications 16 à 18, dans lequel la couche conductrice (400) ou la couche chauffante (300) a une épaisseur de 2 mm à 500 mm.

**32.** Étoffe chauffante selon l'une quelconque des revendications 16 à 18, dans lequel la couche conductrice (400) a une épaisseur de 10 mm à 20 mm.

**33.** Étoffe chauffante selon l'une quelconque des revendications 16 à 18, dans lequel la couche d'isolation (500) est formée par enduction, impression ou stratification d'au moins une résine choisie parmi le groupe consistant en des résines de polyuréthane, acryliques, de silicone, de polyester, de poly(chlorure de vinyle) (PVC) et de polytétrafluoroéthylène (PTFE) sur la couche conductrice.

**34.** Étoffe chauffante selon l'une quelconque des revendications 16 à 18, dans lequel la couche d'isolation (500) est formée par séchage en cas d'enduction directe ou par points à chaud ou gravure en cas de stratification.

**35.** Procédé selon l'une quelconque des revendications 16 à 18, dans lequel la couche conductrice (400) a les parties élargies (450) de parties courbes (430) d'un circuit dont la largeur est plus grande que celle de parties linéaires (410) du circuit.

**36.** Procédé selon la revendication 35, dans lequel les parties élargies (450) ont une forme circulaire ou ovale.

**37.** Procédé selon l'une quelconque des revendications 16 à 18, dans lequel l'étoffe chauffante (10) a une différence de résistance de 0,5 $\Omega$ à 4 $\Omega$ avant et après lavage.

[Fig. 1]

[Fig. 2]

[Fig. 3]

[Fig. 4]

```
┌─────────────────────────────────────┐
│      Water repellent finishing       │
└─────────────────────────────────────┘
                    │
                    ▼
┌─────────────────────────────────────┐
│            Calendering               │
└─────────────────────────────────────┘
                    │
                    ▼
┌─────────────────────────────────────┐
│         Forming primer payer         │
└─────────────────────────────────────┘
                    │
                    ▼
┌─────────────────────────────────────┐
│      Forming a heating layer         │
│      and/or conductive layer         │
└─────────────────────────────────────┘
                    │
                    ▼
┌─────────────────────────────────────┐
│       Forming insulating layer       │
└─────────────────────────────────────┘
```

[Fig. 5]

```
┌─────────────────────────────────────┐
│            Calendering               │
└─────────────────────────────────────┘
                    │
                    ▼
┌─────────────────────────────────────┐
│      Water repellent finishing       │
│        /Forming primer payer         │
└─────────────────────────────────────┘
                    │
                    ▼
┌─────────────────────────────────────┐
│      Forming a heating layer         │
│      and/or conductive layer         │
└─────────────────────────────────────┘
                    │
                    ▼
┌─────────────────────────────────────┐
│       Forming insulating layer       │
└─────────────────────────────────────┘
```

[Fig. 6]

[Fig. 7]

Elongation variation in coating a heating fabric with silicon/PU according to a kind of binders added to conductive polymer.

[Fig. 8]

[Fig. 9]

Tensile strength in case that heating pattern is printed or is not printed according to one surface or both surfaces thereof coating with silicon

one surface coating

both surfaces coating

method for coating silicon

42.62 · 41.583

39.59

32.823

tensile strength(kgf)

50 40 30 20 10 0

☐ printing heating pattern existence, printing heating pattern non-existence X
▨ printing heating pattern existence, printing heating pattern non-existence O

[Fig. 10]

EP 2 094 905 B1

Elongation if heating pattern is printed or is not printed according to one
surface or both surfaces coating

method for coating silicon

☐ printing heating pattern existence, printing heating pattern non-existence X

▨ printing heating pattern existence, printing heating pattern non-existence O

[Fig. 11]

resistance variation in printing silver-conductive polymer on heating fabric(%)

the number of times(count)

resistance variation(%)

□ one surface coating   ▨ both surfaces coating

resistance variation in printing conductive polymer on heating fabric-silver(%)

the number of times(count)

□ one surface coating ▨ both surfaces coating

[Fig. 12]

EP 2 094 905 B1

**EP 2 094 905 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3935422 A

- US 20040055699 A1